# EUROPEAN PATENT APPLICATION

(11) **EP 4 773 770 A1**
(43) Date of publication of application: **08.07.2026**
(21) Application number: 24906410.6
(22) Date of filing: 18.12.2024
(51) Int. Cl.: H10K 59/12

(54) **DISPLAY PANEL AND DISPLAY APPARATUS**

(30) Priority: 22.12.2023 CN 202311790084
(71) Applicant: Boe Technology Group Co., Ltd., Beijing 100015 (CN); Beijing BOE Technology Development Co., Ltd., Daxing District Beijing 100176 (CN)
(72) Inventor: LV, Guangshuang, Beijing 100176 (CN); XU, Pan, Beijing 100176 (CN); HAN, Ying, Beijing 100176 (CN); ZHANG, Xing, Beijing 100176 (CN); LUO, Chengyuan, Beijing 100176 (CN); ZHAO, Donghui, Beijing 100176 (CN); ZHANG, Dacheng, Beijing 100176 (CN); ZHOU, Dandan, Beijing 100176 (CN)
(74) Representative: Potter Clarkson
(86) International application number: PCT/CN2024/140340
(87) International publication number: WO 2025/130931

(57) **Abstract**

The present disclosure belongs to the technical field of display, and provides a display panel and a display apparatus. The display panel comprises a base substrate, a driving layer and a pixel layer, which are stacked in sequence. The driving layer comprises a first metal layer, a semiconductor layer, a gate insulation layer, a second metal layer and a planarization layer, which are stacked in sequence on the base substrate. The driving layer comprises a pixel driving circuit, which is arranged in an array and is used for driving the pixel layer. The pixel driving circuit comprises a first transistor, a second transistor, a third transistor and a storage capacitor, each transistor comprising a gate electrode, a first electrode and a second electrode. The display panel comprises a scanning signal line, and the gate electrode of the third transistor, and the first electrode and second electrode of the third transistor, are all located on the same side of the scanning signal line. In the described display panel, disposing thin film transistors on the same side of a scanning signal line helps to increase an aperture ratio, while still satisfying layout space and processing requirements.

## Description

### CROSS REFERENCE

This disclosure claims priority to Chinese Patent Application No. 202311790084.9, entitled "Display Panel and Display Device", filed on December 22, 2023, the entire contents of which are incorporated herein by reference.

### TECHNICAL FIELD

The present disclosure relates to the field of display technologies, and in particular relates to a display panel and a display device.

### BACKGROUND

At present, high-end displays and gaming displays are required to have characteristics of a high number of pixels per inch, a high refresh rate, and low latency. When the number of pixels per inch is higher, layout space for pixels becomes tighter, and requirements for process accuracy become higher. Therefore, it is necessary to reasonably distribute patterns of each layer within limited layout space, so as to increase an aperture ratio and extend a service life of OLED devices.

### SUMMARY

An objective of this disclosure is to overcome deficiencies of the above related art and to provide a display panel and a display device, which are beneficial to increasing an aperture ratio.

According to a first aspect of this disclosure, a display panel is provided. The display panel includes a substrate base, a driving layer, and a pixel layer that are sequentially stacked, and the driving layer includes a first metal layer, a semiconductor layer, a gate insulating layer, a second metal layer, and a planarization layer that are sequentially stacked on the substrate base.

The driving layer includes pixel driving circuits arranged in an array for driving the pixel layer; wherein the pixel driving circuit includes a first transistor, a second transistor, a third transistor, and a storage capacitor, wherein each transistor includes a gate, a first terminal, and a second terminal.

The display panel includes a scan signal line, and a gate, a first terminal, and a second terminal of the third transistor are all located on the same side of the scan signal line.

According to one embodiment of this disclosure, a pixel opening of a sub-pixel driven by the pixel driving circuit and the third transistor of the pixel driving circuit are respectively located on two sides of the scan signal line.

According to one embodiment of this disclosure, the second metal layer includes a first metal structure, the first metal structure is electrically connected to a second electrode plate of the storage capacitor through a fifth via hole, and the first metal structure is electrically connected to the second terminal of the third transistor through a second via hole; the driving layer is further provided with a transparent conductive layer, and the second electrode plate of the storage capacitor is located in the transparent conductive layer.

The planarization layer includes a pixel electrode via hole exposing at least a partial region of the first metal structure, and the pixel electrode via hole and the pixel opening are respectively located on two sides of the scan signal line.

According to one embodiment of this disclosure, the third transistor further includes a channel region of the third transistor located in the semiconductor layer, and a length direction of the channel region of the third transistor is a row direction; the first terminal of the third transistor is electrically connected to the second metal layer through a first via hole, and the second terminal of the third transistor is electrically connected to the second metal layer through a second via hole; a length direction of the first via hole and a length direction of the second via hole are both a column direction.

The scan signal line extends along the row direction, and the scan signal line includes a first scan signal line branch protruding along the column direction toward a side away from the pixel opening; the first scan signal line branch includes a gate of the third transistor, and the channel region of the third transistor overlaps the gate of the third transistor.

According to one embodiment of this disclosure, the second transistor and the third transistor are respectively disposed on two sides of the scan signal line, the second transistor includes a channel region of the second transistor located in the semiconductor layer, and a length direction of the channel region of the second transistor is the row direction;
the scan signal line has a second scan signal line branch protruding along the column direction, the second scan signal line branch includes a gate of the second transistor, and the gate of the second transistor overlaps the channel region of the second transistor.

According to one embodiment of this disclosure, the scan signal line is located in the second metal layer.

According to one embodiment of this disclosure, the display panel includes a data signal line, and the data signal line is located in the first metal layer;
the second metal layer includes a second metal structure, the second metal structure is electrically connected to the data signal line through a third via hole, and is electrically connected to the first terminal of the second transistor through a sixth via hole.

According to one embodiment of this disclosure, the first terminal of the second transistor extends along the column direction; an orthographic projection of the first terminal of the second transistor in the column direction partially overlaps an orthographic projection of the pixel opening in the column direction.

According to one embodiment of this disclosure, the scan signal line has a second scan signal line branch protruding along the column direction, and a gap is present between an orthographic projection of the second scan signal line branch in the column direction and an orthographic projection of the second metal structure in the column direction.

According to one embodiment of this disclosure, along the row direction, the channel region of the third transistor is located between the channel region of the second transistor and the data signal line.

According to one embodiment of this disclosure, an orthographic projection of the first terminal of the second transistor in the column direction does not overlap an orthographic projection of the pixel opening in the column direction.

According to one embodiment of this disclosure, the scan signal line includes a second scan signal line branch protruding along the column direction, and an orthographic projection of the second scan signal line branch in the column direction at least partially overlaps an orthographic projection of the second metal structure in the column direction.

According to one embodiment of this disclosure, the display panel includes pixel driving circuit groups arranged in an array, each pixel driving circuit group includes four pixel driving circuits disposed in the same row; the four pixel driving circuits are connected to a same sensing signal line;
wherein two of the pixel driving circuits are located on one side of the sensing signal line, and the other two pixel driving circuits are located on the other side of the sensing signal line.

According to one embodiment of this disclosure, in a same pixel driving circuit, the second transistor and the third transistor are respectively disposed on the same side of the scan signal line; the scan signal line has a first scan signal line branch and a second scan signal line branch protruding along the column direction, the first scan signal line branch overlaps the channel region of the third transistor, and the channel region of the second transistor overlaps the second scan signal line branch.

According to one embodiment of this disclosure, the channel region of the second transistor and the channel region of the third transistor are arranged along the row direction; the channel region of the second transistor is located on a side of the channel region of the third transistor away from the sensing signal line.

According to one embodiment of this disclosure, the display panel includes pixel driving circuit groups arranged in an array, each pixel driving circuit group includes four pixel driving circuits connected to a same sensing signal line;
wherein two of the pixel driving circuits are located on one side of the sensing signal line, and the other two pixel driving circuits are located on the other side of the sensing signal line; two of the pixel driving circuits are located on one side of the scan signal line, and the other two pixel driving circuits are located on the other side of the scan signal line.

According to one embodiment of this disclosure, third transfer lines corresponding to the sensing signal line are respectively disposed on two sides of the scan signal line;
first terminals of two third transistors located on the same side of the scan signal line are both electrically connected to the sensing signal line through the third transfer line on the same side.

According to one embodiment of this disclosure, the pixel driving circuit includes a first transistor, a second transistor, a third transistor, and a storage capacitor, wherein a first terminal of the first transistor is electrically connected to a driving power voltage signal line for loading a driving power voltage; a first terminal of the second transistor is electrically connected to a data signal line for loading a data voltage; a first terminal of the third transistor is electrically connected to a sensing signal line;
a gate of the first transistor is electrically connected to a second terminal of the second transistor and a first electrode plate of the storage capacitor; a second terminal of the first transistor is electrically connected to a second terminal of the third transistor, a pixel electrode of the pixel layer, and a second electrode plate of the storage capacitor; gates of the second transistor and the third transistor are respectively electrically connected to the scan signal line for loading a scan signal.

According to one embodiment of this disclosure, the display panel includes circuit pairs arranged in an array, each circuit pair includes two pixel driving circuits adjacent in the same row;
in a same circuit pair, a first terminal of a third transistor of one pixel driving circuit is reused as a first terminal of a third transistor of the other pixel driving circuit.

According to one embodiment of this disclosure, the pixel driving circuit includes a first transistor, a second transistor, a third transistor, and a storage capacitor, wherein a first terminal of the first transistor is electrically connected to a driving power voltage signal line for loading a driving power voltage; a first terminal of the second transistor is electrically connected to a data signal line for loading a data voltage; a first terminal of the third transistor is electrically connected to a sensing signal line; a gate of the first transistor is electrically connected to a second terminal of the second transistor and a first electrode plate of the storage capacitor; a second terminal of the first transistor is electrically connected to a second terminal of the third transistor, a pixel electrode of the pixel layer, and a second electrode plate of the storage capacitor;
the scan signal line includes a first scan signal line and a second scan signal line; a gate of the second transistor is electrically connected to the first scan signal line, and a gate of the third transistor is electrically connected to the second scan signal line;
a gate, a first terminal, and a second terminal of the third transistor are all located on the same side of the second scan signal line.

According to one embodiment of this disclosure, the planarization layer has a pixel electrode via hole, and a pixel electrode of the pixel layer is electrically connected to an output terminal of the pixel driving circuit through the pixel electrode via hole;
a pixel opening of a sub-pixel driven by the pixel driving circuit and a pixel electrode opening corresponding to the pixel driving circuit are respectively located on two sides of the scan signal line to which the gate of the third transistor is connected.

According to one embodiment of this disclosure, the second metal layer includes a first metal structure, the first metal structure is electrically connected to a second electrode plate of the storage capacitor through a fifth via hole, and the first metal structure is electrically connected to the second terminal of the third transistor through a second via hole; an orthographic projection of the pixel electrode via hole on the substrate base overlaps at least one of an orthographic projection of the fifth via hole on the substrate base and an orthographic projection of the second via hole on the substrate base.

According to a second aspect of this disclosure, a display device is provided, the display device includes the display panel described above.

In the display panel of this disclosure, thin film transistors are disposed on the same side of the scan signal line, which is beneficial to increasing an aperture ratio under a premise of satisfying layout space and process requirements.

It should be understood that the above general description and the following detailed description are only exemplary and explanatory, and are not intended to limit this disclosure.

### BRIEF DESCRIPTION OF THE DRAWINGS

The drawings herein are incorporated into and constitute a part of this specification, illustrate embodiments consistent with this disclosure, and together with the specification are used to explain principles of this disclosure. Apparently, the drawings in the following description are merely some embodiments of this disclosure, and for those of ordinary skill in the art, other drawings may also be obtained based on these drawings without creative effort.
FIG. 1 is a schematic structural diagram of a display panel in one embodiment of this disclosure.
FIG. 2 is a schematic diagram of a film layer structure of a display panel in one embodiment of this disclosure.
FIG. 3 is an equivalent circuit diagram of a 3T1C pixel driving circuit in one embodiment of this disclosure.
FIG. 4 is a schematic diagram of a four-in-one layout design of thin film transistors of a display panel in one embodiment of this disclosure.
FIG. 5 is a schematic diagram of a layout design in which adjacent thin film transistor source and drain electrodes are shared in a display panel in one embodiment of this disclosure.
FIG. 6 is a partial enlarged schematic diagram of FIG. 5.
FIG. 7 is a schematic structural diagram of a third transistor in one embodiment of this disclosure.
FIG. 8 is a schematic diagram of a layout design in which thin film transistors are connected using a conductorized second transfer line in one embodiment of this disclosure.
FIG. 9 is a partial enlarged schematic diagram of FIG. 8.
FIG. 10 is a schematic diagram of a positional relationship between a second metal layer and a pixel electrode via hole in FIG. 5.
FIG. 11 is a partial cross-sectional structural schematic diagram at a pixel electrode via hole in FIG. 5.
FIG. 12 is a structural schematic diagram of a positional relationship between a second metal layer and a pixel electrode via hole in FIG. 8.
FIG. 13 is a partial cross-sectional structural schematic diagram at a pixel electrode via hole in FIG. 8.
FIG. 14 is a schematic diagram of a film layer layout design of a display panel in one embodiment of this disclosure.
FIG. 15 is a schematic diagram of a film layer layout design of a display panel in a first embodiment of this disclosure.
FIG. 16 is a schematic diagram of a connection structure of a pixel driving circuit in a first embodiment of this disclosure.
FIG. 17 is a schematic diagram showing that a pixel opening and a third transistor are located on two sides of a scan signal line in a first embodiment of this disclosure.
FIG. 18 is a schematic diagram showing a connection between a first metal structure and a second terminal of a third transistor in a first embodiment of this disclosure.
FIG. 19 is a schematic diagram showing a positional relationship between a scan signal line and a third transistor in a first embodiment of this disclosure.
FIG. 20 is a schematic diagram showing a positional relationship between a scan signal line and a second transistor in a first embodiment of this disclosure.
FIG. 21 is a schematic diagram showing a connection between a second metal structure and a first terminal of a second transistor in a first embodiment of this disclosure.
FIG. 22 is a schematic diagram showing a positional relationship between a first terminal of a second transistor and a pixel opening in a first embodiment of this disclosure.
FIG. 23 is a schematic diagram showing a positional relationship between a second scan signal line branch and a second metal structure in a first embodiment of this disclosure.
FIG. 24 is a schematic diagram of a film layer layout design of a display panel in a second embodiment of this disclosure.
FIG. 25 is a schematic diagram of a connection structure of a pixel driving circuit in a second embodiment of this disclosure.
FIG. 26 is a schematic diagram showing a positional relationship between a first scan signal line branch and a second scan signal line branch in a second embodiment of this disclosure.
FIG. 27 is a schematic diagram showing a positional relationship between a first terminal of a second transistor and a pixel opening in a second embodiment of this disclosure.
FIG. 28 is a schematic diagram showing a positional relationship between a second scan signal line branch and a second metal structure in a second embodiment of this disclosure.
FIG. 29 is a schematic diagram of a transparent conductive layer in a second embodiment of this disclosure.
FIG. 30 is a schematic diagram of a first metal layer in a second embodiment of this disclosure.
FIG. 31 is a schematic diagram of a semiconductor layer in a second embodiment of this disclosure.
FIG. 32 is a schematic diagram of a second metal layer in a second embodiment of this disclosure.
FIG. 33 is a schematic diagram showing a positional relationship between partial via holes and a second metal layer in a second embodiment of this disclosure.
FIG. 34 is a schematic diagram showing a positional relationship between a pixel electrode via hole and a second metal layer in a second embodiment of this disclosure.
FIG. 35 is a schematic diagram of pixel electrodes in a pixel electrode layer in a second embodiment of this disclosure.
FIG. 36 is a schematic diagram showing pixel openings on pixel electrodes in a second embodiment of this disclosure.
FIG. 37 is a schematic diagram of a film layer layout design of a display panel in a third embodiment of this disclosure.
FIG. 38 is a schematic diagram of a connection structure of a pixel driving circuit in a third embodiment of this disclosure.
FIG. 39 is a schematic diagram showing a positional relationship between a second scan signal line branch and a channel region of a second transistor in a third embodiment of this disclosure.
FIG. 40 is a schematic diagram showing a positional relationship between a channel region of a second transistor and a channel region of a third transistor in a third embodiment of this disclosure.
FIG. 41 is a schematic diagram showing a connection between a third metal structure and a second terminal of a first transistor in a third embodiment of this disclosure.
FIG. 42 is a schematic diagram showing a connection between a first terminal of a third transistor and a sensing signal line in a third embodiment of this disclosure.
FIG. 43 is a schematic diagram of a stacked structure layout of a first metal layer and a second metal layer in a fourth embodiment of this disclosure.
FIG. 44 is a schematic diagram of a stacked structure layout of a first metal layer and a transparent conductive layer in a fourth embodiment of this disclosure.
FIG. 45 is a schematic diagram of a stacked structure layout of a first metal layer, a transparent conductive layer, and a semiconductor layer in a fourth embodiment of this disclosure.
FIG. 46 is a partial schematic diagram showing a relative positional relationship among a via hole, a pixel opening, and a second metal layer in a fourth embodiment of this disclosure.
FIG. 47 is a cross-sectional structural schematic diagram showing a semiconductor layer disconnection defect occurring at an edge of a metal transfer portion in a fourth embodiment of this disclosure.
FIG. 48 is a cross-sectional structural schematic diagram at an edge of a metal transfer portion in one example of a fourth embodiment of this disclosure.
FIG. 49 is a cross-sectional structural schematic diagram at an edge of a metal transfer portion in another example of a fourth embodiment of this disclosure.
FIG. 50 is a cross-sectional schematic diagram showing a relative positional relationship between a fifth via hole and a pixel electrode via hole in one example of a fourth embodiment of this disclosure.
FIG. 51 is a cross-sectional schematic diagram showing a relative positional relationship between a fifth via hole and a pixel electrode via hole in another example of a fourth embodiment of this disclosure.
FIG. 52 is a schematic diagram showing a relative positional relationship among a second metal layer, a pixel electrode via hole, and a pixel opening in a fifth embodiment of this disclosure.
FIG. 53 is a schematic diagram of a stacked structure between a second metal layer and a semiconductor layer in a fifth embodiment of this disclosure.
FIG. 54 is a schematic diagram of a stacked structure between a first metal layer and a semiconductor layer in a fifth embodiment of this disclosure.
FIG. 55 is a schematic diagram of a stacked structure between a first metal layer and a transparent conductive layer in a fifth embodiment of this disclosure.

### Description of the reference signs

AA, display area; BB, peripheral area; BUF, inorganic buffer layer; COML, common electrode layer; CR, channel region; CS, conductive structure; CST, storage capacitor; CST1, first electrode plate of storage capacitor; CST2, second electrode plate of storage capacitor; DH, row direction; DL, data signal line; DRL, driving layer; DV, column direction; EFL, light-emitting functional layer; GL, scan signal line; GLA, scan signal line branch; GLA1, first scan signal line branch; GLA2, second scan signal line branch; GI, gate insulating layer; GS, scan signal; GT, second metal layer; GX1, first metal structure; GX1H, pixel electrode via hole; GX2, second metal structure; GX3, third metal structure; GX4, fourth metal structure; HA, first via hole; HB, second via hole; HC, third via hole; HD, fourth via hole; HE, fifth via hole; HF, sixth via hole; HG, seventh via hole; HL, lateral transfer line; ITO1, transparent conductive layer; NG, first node; NS, second node; PDC, pixel driving circuit; PDCS, pixel driving circuit group; PDL, pixel definition layer; PEL, pixel electrode layer; PE, pixel electrode; PIXL, pixel layer; PIX, sub-pixel; PLN, planarization layer; PNL, display panel; PO, pixel opening; PVX, passivation layer; SBT, substrate base; SCL, semiconductor layer; SHL, first metal layer; SL, sensing signal line; SX, light-shielding portion; T1, first transistor; T1G, gate of first transistor; T2, second transistor; T2A, channel region of second transistor; T2S, first terminal of second transistor; T3, third transistor; T3A, channel region of third transistor; T3L, transfer structure; T3LA, first transfer line; T3LA1, first segment of first transfer line; T3LA2, second segment of first transfer line; T3LB, second transfer line; T3LC, third transfer line; T3S, first terminal of third transistor; T3D, second terminal of third transistor; TFT, thin film transistor; TX, reuse structure; VDD, driving power voltage; VDDL, driving power voltage signal line; VSS, reference power voltage; UU, display unit.

### DETAILED DESCRIPTION

Example embodiments will now be described more fully with reference to the accompanying drawings. However, example embodiments can be implemented in various forms and should not be understood as being limited to the embodiments set forth herein; on the contrary, these embodiments are provided so that this disclosure will be comprehensive and complete, and will fully convey the concept of the example embodiments to those skilled in the art. The same reference signs in the drawings denote the same or similar structures, and therefore detailed descriptions thereof will be omitted. In addition, the drawings are only schematic illustrations of this disclosure and are not necessarily drawn to scale.

Although relative terms such as "upper" and "lower" are used in this specification to describe a relative relationship of one component of a drawing with respect to another component, these terms are used in this specification only for convenience, for example, according to directions of examples shown in the drawings. It can be understood that if a device shown in the drawings is turned upside down, a component described as being "upper" will become a component that is "lower". When a structure is described as being "on" another structure, it may mean that the structure is integrally formed on another structure, or that the structure is "directly" disposed on another structure, or that the structure is "indirectly" disposed on another structure through another structure.

The terms "one", "a", "the", "said", and "at least one" are used to indicate the presence of one or more elements/components/etc.; the terms "include" and "have" are used to indicate an open-ended inclusion and mean that, in addition to listed elements/components/etc., other elements/components/etc. may also exist; the terms "first", "second", "third", and the like are used only as labels and are not limitations on the quantity of their objects.

In embodiments of this disclosure, a thin film transistor has an active layer. The active layer is located in a semiconductor layer and includes a channel region and a source electrode and a drain electrode respectively located on two sides of the channel region. The channel region maintains semiconductor characteristics, and the source electrode and the drain electrode are partially or fully conductorized. In embodiments of this disclosure, in cases such as using transistors with opposite polarities or changes in current direction during circuit operation, functions of the "source electrode" and the "drain electrode" are sometimes exchanged, that is, the "source electrode" and the "drain electrode" can be exchanged with each other. In embodiments of this disclosure, for any transistor, one of a "first terminal" and a "second terminal" is referred to as a source electrode of the transistor, and the other is referred to as a drain electrode of the transistor.

In embodiments of this disclosure, a channel region of a transistor has a length direction and a width direction. The length direction of the channel region of the transistor refers to a direction in which current mainly flows, and the width direction of the channel region of the transistor is perpendicular to the direction in which current flows. Along the length direction of the channel region of the transistor, the active layer of the transistor sequentially includes a first terminal of the transistor, the channel region, and a second terminal.

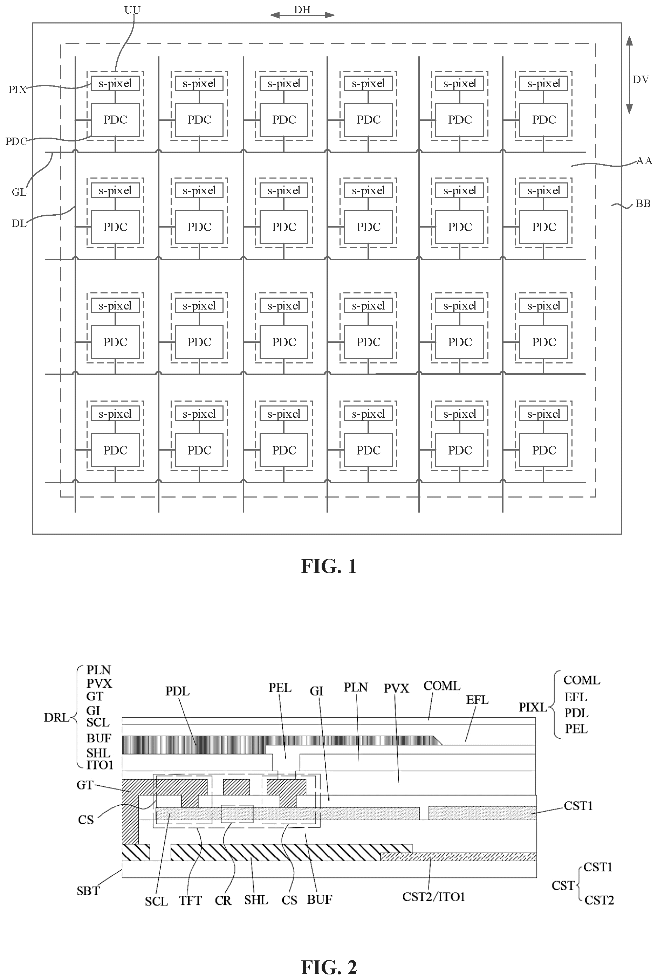

Embodiments of this disclosure provide a display panel PNL. Referring to FIG. 1, the display panel PNL includes a display area AA and a peripheral area BB located on at least one side of the display area AA, for example, the peripheral area BB surrounds the display area AA. In the display area AA, the display panel PNL is provided with display units UU distributed in an array. Each display unit UU includes a sub-pixel PIX and a pixel driving circuit PDC for driving the sub-pixel PIX. The display panel PNL does not provide display units UU in the peripheral area BB, or the display units UU provided in the peripheral area BB are not used for displaying images. Referring to FIG. 1, the display panel PNL is provided in the display area AA with a plurality of scan signal lines GL extending along a row direction DH, and each scan signal line GL is provided corresponding to each row of display units. Pixel driving circuits PDC of the display units UU in each row of display units are electrically connected to a corresponding scan signal line GL. The display panel PNL is further provided in the display area AA with a plurality of data signal lines DL extending along a column direction DV, and each data signal line DL is provided corresponding to each column of display units. Pixel driving circuits PDC of the display units UU in each column of display units are electrically connected to a corresponding data signal line DL. Thus, each pixel driving circuit PDC of each display unit UU is connected to one scan signal line GL and one data signal line DL. When a scan signal is loaded on the scan signal line GL, a driving voltage loaded on the data signal line DL can be written into the pixel driving circuit PDC, such that the pixel driving circuit PDC can control brightness of the sub-pixel PIX according to the written driving voltage.

Optionally, the pixel driving circuit PDC at least includes a data writing transistor, a driving transistor, and a storage capacitor CST, and a gate of the driving transistor can be electrically connected to one electrode plate of the storage capacitor CST. A source electrode of the data writing transistor can be electrically connected to the data signal line DL, and a gate of the data writing transistor can be electrically connected to the scan signal line GL. The pixel driving circuit PDC is configured such that, when a scan signal GS is loaded on the scan signal line GL, the data writing transistor is turned on, thereby writing a driving voltage on the data signal line DL into the gate of the driving transistor and the storage capacitor CST. After the data writing transistor is turned off, the driving voltage can be held by the storage capacitor CST. The driving transistor can output a driving current under control of a voltage on its gate to drive the sub-pixel PIX to emit light. It can be understood that the pixel driving circuit PDC in embodiments of this disclosure can further include other transistors or capacitors, so that the pixel driving circuit PDC has better driving performance. For example, the pixel driving circuit PDC can be a 7T1C pixel driving circuit (seven thin film transistors TFT and one storage capacitor CST), an 8T1C pixel driving circuit (eight thin film transistors TFT and one storage capacitor CST), or a pixel driving circuit PDC of another architecture.

In embodiments of this disclosure, the sub-pixel PIX in the display panel PNL is a current-driven self-luminous element, for example, a thin-film type self-luminous light-emitting element. For example, the sub-pixel PIX is an OLED, a PLED, or a QLED. Further, the sub-pixels PIX located in the display area AA include a plurality of sub-pixels PIX of different colors. For example, the sub-pixels PIX include red sub-pixels for emitting red light, green sub-pixels for emitting green light, and blue sub-pixels for emitting blue light. It can be understood that in other embodiments of this disclosure, the sub-pixels PIX in the display area AA may also be sub-pixels of only one color, or may also have sub-pixels PIX of other colors (for example, yellow sub-pixels for emitting yellow light, cyan sub-pixels for emitting cyan light, white sub-pixels for emitting white light, and the like).

In one embodiment of this disclosure, referring to FIG. 2, the display panel PNL may include a substrate base SBT, a driving layer DRL, and a pixel layer PIXL that are sequentially stacked. The pixel layer PIXL is provided with sub-pixels PIX, and the driving layer DRL is provided with pixel driving circuits PDC for driving the sub-pixels PIX. Each sub-pixel PIX can emit light under driving of the pixel driving circuit PDC to display images.

Optionally, the substrate base SBT may be an inorganic material substrate base or an organic material substrate base; of course, it may also be a composite substrate base formed by stacking an inorganic material substrate base and an organic material substrate base. For example, in some embodiments of this disclosure, the material of the substrate base SBT may be soda-lime glass, quartz glass, sapphire glass, or other glass materials. In some other embodiments of this disclosure, the material of the substrate base SBT may be polymethyl methacrylate, polyvinyl alcohol, polyvinyl phenol, polyethersulfone, polyimide, polyamide, polyoxymethylene, polycarbonate, polyethylene terephthalate, polyethylene naphthalate, or a combination thereof. In still other embodiments of this disclosure, the substrate base SBT may also be a flexible substrate base, for example, the material of the substrate base SBT may include polyimide.

Optionally, referring to FIG. 2, in the driving layer DRL, at least one pixel driving circuit PDC may include a thin film transistor TFT and a storage capacitor CST. Further, the thin film transistor TFT may be selected from a top-gate thin film transistor, a bottom-gate thin film transistor, or a dual-gate thin film transistor; a material of an active layer of the thin film transistor TFT may be an amorphous silicon semiconductor material, a low-temperature polycrystalline silicon semiconductor material, a metal oxide semiconductor material, an organic semiconductor material, a carbon nanotube semiconductor material, or another type of semiconductor material; the thin film transistor TFT may be an N-type thin film transistor or a P-type thin film transistor.

In one example, the transistors in the driving layer DRL are top-gate thin film transistors.

In one example, the transistors in the driving layer DRL are metal oxide thin film transistors.

As one example, referring to FIG. 2, the driving layer DRL may include a first metal layer SHL, an inorganic buffer layer BUF, a semiconductor layer SCL, a gate insulating layer GI, a second metal layer GT, and a planarization layer PLN that are sequentially stacked, such that the formed thin film transistor TFT is a top-gate thin film transistor. In this example, a source/drain metal layer may not be provided, thereby reducing a thickness of the display panel PNL. At the same time, patterning processes can be reduced, which is beneficial to reducing costs of the display panel.

In this embodiment, at least part of structures of the first metal layer SHL may serve as a light-shielding structure, and the light-shielding structure shields a channel region CR of the transistor, so as to avoid light irradiating the channel region CR of the transistor from a side of the substrate base and causing characteristics of the transistor to change. For example, an orthographic projection of the channel region CR of the transistor on the substrate base SBT is located within an orthographic projection of the first metal layer SHL on the substrate base SBT.

Further, referring to FIG. 2, the first metal layer SHL and the second metal layer GT are connected through via holes.

Further, referring to FIG. 2, the driving layer DRL further includes a passivation layer PVX located on a side of the second metal layer GT away from the substrate base SBT, and the planarization layer PLN is located on a side of the passivation layer PVX away from the substrate base SBT.

In one embodiment of this disclosure, referring to FIG. 2, the driving layer DRL further includes a transparent conductive layer ITO1. The transparent conductive layer ITO1 is used to form one electrode plate of the storage capacitor CST, and the semiconductor layer SCL is used to form another electrode plate of the storage capacitor CST. Thus, the storage capacitor CST is a transparent storage capacitor. Further, light emitted by the sub-pixel PIX can be emitted through the transparent storage capacitor, such that the display panel PNL is a bottom-emission display panel. Further, the transparent conductive layer ITO1 is located between the first metal layer SHL and the substrate base SBT. Specifically, during fabrication of the display panel PNL, the transparent conductive layer ITO1 can be formed first, and then the first metal layer SHL is formed.

Optionally, a material of the transparent conductive layer ITO1 may be a transparent conductive metal oxide, for example, indium tin oxide.

Optionally, a material of the first metal layer SHL may be a metal. For example, the first metal layer SHL includes one metal layer or multiple stacked metal layers.

Optionally, when the transparent conductive layer ITO1 is electrically connected to the first metal layer SHL, a portion of structures of the first metal layer SHL is directly lapped over the transparent conductive layer ITO1.

In the example of FIG. 2, the pixel layer PIXL includes light-emitting elements corresponding to the sub-pixels PIX. The pixel layer PIXL may include a pixel electrode layer PEL, a light-emitting functional layer EFL, and a common electrode layer COML (for loading a reference power voltage) that are sequentially stacked. The pixel electrode layer PEL has a plurality of pixel electrodes PE in the display area of the display panel, and the pixel electrodes PE are electrically connected to the pixel driving circuits PDC through via holes.

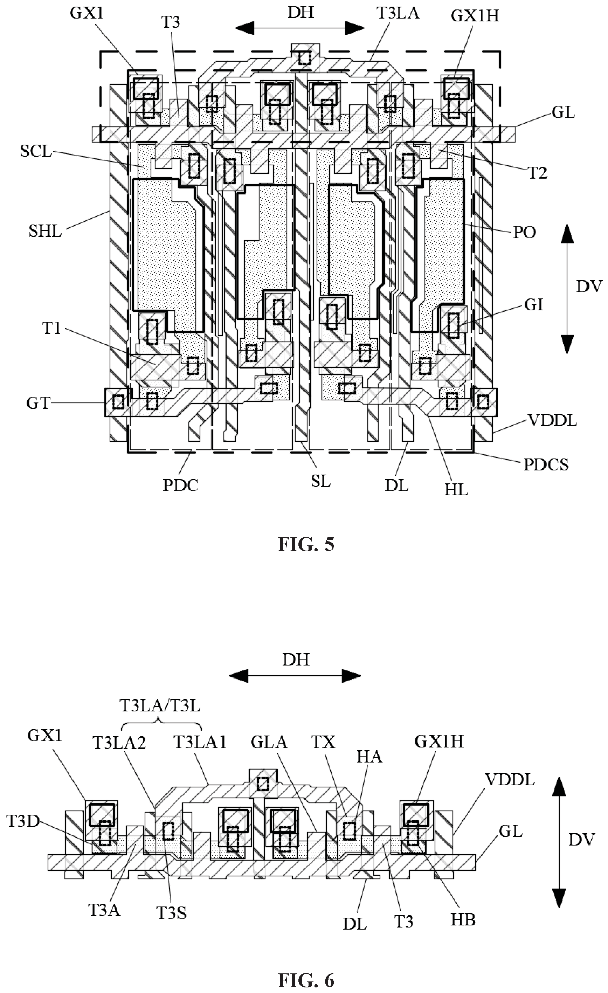

Further, referring to FIG. 2, the pixel layer PIXL may further include a pixel definition layer PDL located between the pixel electrode layer PEL and the light-emitting functional layer EFL. The pixel definition layer PDL has a plurality of through pixel openings PO provided corresponding one-to-one with the plurality of pixel electrodes PE (as shown in FIG. 5), and any one pixel opening PO exposes at least part of a region of a corresponding pixel electrode PE.

In one example, the pixel electrode PE serves as an anode of the sub-pixel PIX, and the common electrode layer COML serves as a cathode of the sub-pixel PIX.

Optionally, the common electrode layer COML is a reflective electrode rather than a transparent electrode, for example, a metal electrode or a metal oxide electrode. The pixel electrode PE is a transparent electrode. For example, a material of the pixel electrode PE is a transparent conductive metal oxide (for example, indium tin oxide). Thus, the sub-pixel PIX is a bottom-emission sub-pixel.

In one example, the common electrode layer COML may be a metal electrode layer. For example, the common electrode layer COML may be a silver metal layer, an aluminum metal layer, a titanium metal layer, or another metal layer with high reflectivity. Of course, when necessary, a surface of the metal electrode layer may also be modified using an alloy, a metal oxide, a metal nitride, or another material, to adjust carrier injection characteristics (for example, electron injection characteristics) of the metal electrode layer. For example, the material of the common electrode layer COML is aluminum, and a thickness thereof is 100 nanometers.

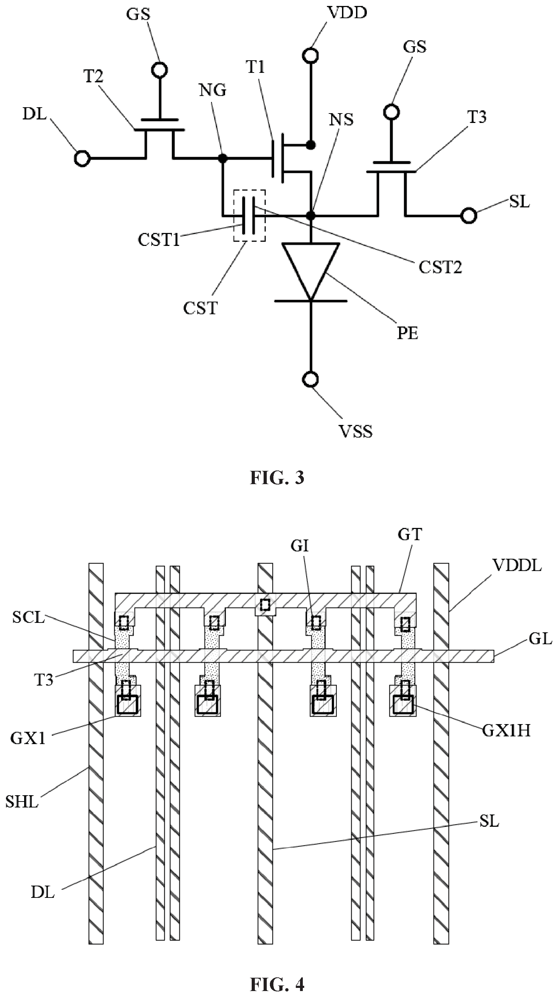

In one embodiment of this disclosure, referring to FIG. 3, a pixel driving circuit PDC in a driving layer DRL is a 3T1C circuit, that is, includes a first transistor T1 (as a driving transistor), a second transistor T2 (as a data writing transistor), a third transistor T3 (as a sensing transistor), and a storage capacitor CST. A first terminal of the first transistor T1 is electrically connected to a driving power voltage signal line VDDL for loading a driving power voltage VDD; a first terminal of the second transistor T2 (marked as T2S in some drawings) is electrically connected to a data signal line DL for loading a data voltage; a first terminal of the third transistor T3 (marked as T3S in some drawings) is electrically connected to a sensing signal line SL; a gate of the first transistor T1 is electrically connected to a second terminal of the second transistor T2 and a first electrode plate CST1 of the storage capacitor; and a second terminal of the first transistor T1 is electrically connected to a second terminal of the third transistor T3 (marked as T3D in some drawings), a pixel electrode PE of a sub-pixel PIX, and a second electrode plate CST2 of the storage capacitor.

Optionally, the second terminal of the second transistor T2, the first electrode plate CST1 of the storage capacitor, and the gate T1G of the first transistor are respectively electrically connected to a first node NG, and the second terminal T3D of the third transistor, the second terminal of the first transistor T1, the pixel electrode PE, and the second electrode plate CST2 of the storage capacitor are respectively electrically connected to a second node NS.

Optionally, the driving power voltage signal line VDDL is disposed in a first metal layer SHL. Optionally, the driving power voltage signal line VDDL extends along a column direction DV.

Optionally, the driving power voltage signal line VDDL is connected to the first terminal of the first transistor T1 through a lateral transfer line HL (for example, referring to FIG. 5). In one example, the lateral transfer line HL is disposed in a second metal layer GT and extends along a row direction DH; the driving power voltage signal line VDDL is disposed in the first metal layer SHL and extends along the column direction DV; the lateral transfer line HL intersects the first metal layer SHL and is electrically connected at an intersection position through a via hole. The lateral transfer line HL is further electrically connected to the first terminal of the first transistor T1 through a via hole.

In one example, lateral transfer lines HL adjacent in the same row are connected to each other to form an entire lateral transfer line; the entire lateral transfer line is electrically connected to intersecting driving power voltage signal lines VDDL through via holes. In this way, distribution of the driving power voltage signal can be in a grid form, thereby improving uniformity of the driving power voltage signal.

Optionally, the data signal line DL is disposed in the first metal layer SHL. Optionally, the data signal line DL extends along the column direction DV.

In one example, gates of the second transistor T2 and the third transistor T3 are respectively electrically connected to a scan signal line GL for loading a scan signal GS. In this way, a number of scan signal lines can be reduced, layout space can be saved, and resolution of the display panel PNL can be improved.

It can be understood that, in various examples of this disclosure, connection of the gate of the second transistor T2 and the gate of the third transistor T3 to the same scan signal line is taken as an example. In other embodiments of this disclosure, the display panel may also be provided with two scan signal lines to respectively drive the second transistor and the third transistor. For example, the display panel may be provided with a first scan signal line extending along the row direction and a second scan signal line extending along the row direction; the first scan signal line is used to load a first scan signal, and the second scan signal line is used to load a second scan signal; the gate of the second transistor is electrically connected to the first scan signal line, and the gate of the third transistor is electrically connected to the second scan signal line.

Optionally, the scan signal line GL is located in the second metal layer GT. Optionally, the scan signal line GL extends along the row direction DH. At the same time, the second metal layer GT further includes gates of respective transistors.

In one example, the sensing signal line SL is located in the first metal layer SHL, and the sensing signal line SL is configured to provide a sensing signal to the pixel driving circuit PDC. Optionally, the sensing signal line SL extends along the column direction DV.

In an exemplary embodiment, the sensing signal line SL can simultaneously provide sensing signals to pixel driving circuits PDC of four adjacent sub-pixels PIX, that is, the sensing signal line SL has a one-to-four structure. By designing the sensing signal line SL as a one-to-four structure, the display panel PNL of this disclosure saves a number of signal lines, reduces occupied space, has a simple structure and a reasonable layout, fully utilizes layout space, improves space utilization, and is beneficial to improving resolution.

In one example, the second electrode plate CST2 of the storage capacitor is located in the transparent conductive layer ITO1.

In one example, the first electrode plate CST1 of the storage capacitor is located in the semiconductor layer SCL.

In one related technology, referring to FIG. 4, in a display panel PNL, a first terminal and a second terminal of a third transistor T3 are respectively located on two sides of a scan signal line GL. Moreover, a first terminal of each transistor is electrically connected to a transfer routing line located in the second metal layer GT through a via hole, and is electrically connected to the sensing signal line SL through the transfer routing line. This causes a relatively large number of via holes to be provided on the display panel PNL to ensure normal transmission of electrical signals. In addition, length directions of via holes on the first terminal and the second terminal of the third transistor T3 are both the column direction DV, which causes a relatively large size of the third transistor T3 in the column direction DV. These factors compress a pixel opening PO, resulting in a reduction in aperture ratio or a reduction in resolution. In order to optimize a backplane layout and improve an aperture ratio of pixels or resolution of the display panel, the present application optimizes a backplane structure.

In some embodiments of this disclosure, referring to FIG. 5, pixel driving circuits PDC in the driving layer DRL are arranged in an array. A first terminal T3S of a third transistor in at least one pixel driving circuit PDC is reused as a first terminal T3S of a third transistor in an adjacent pixel driving circuit PDC in the row direction DH. In this way, two adjacent third transistors T3 share the same first terminal, thereby reducing layout area of the third transistor T3, which is conducive to compressing layout area of the pixel driving circuit PDC and providing conditions for improving an aperture ratio or improving resolution. In one example, the display panel PNL includes circuit pairs arranged in an array, and each circuit pair includes two pixel driving circuits PDC adjacent in the same row; in the same circuit pair, a first terminal of a third transistor T3 of one pixel driving circuit PDC is reused as a first terminal of a third transistor T3 of the other pixel driving circuit PDC.

In one example, when layout design is performed for a high-PPI bottom-emission OLED device, by using a connection manner in which first terminals of two adjacent third transistors T3 are shared, a number of connection holes can be reduced, thereby saving layout space. In other words, by reusing a first terminal T3S of a third transistor in at least one pixel driving circuit PDC as a first terminal T3S of a third transistor in an adjacent pixel driving circuit PDC, the display panel PNL can improve space utilization and reduce layout area of the pixel driving circuit PDC, thereby improving PPI of the display panel.

In some embodiments of this disclosure, a first terminal T3S and a second terminal T3D of the third transistor are both disposed on the same side of the scan signal line, in particular, disposed on the same side of the scan signal line that drives the third transistor T3.

For example, in the examples of FIGS. 5 and 6, a gate of the third transistor is electrically connected to the scan signal line GL; the first terminal T3S of the third transistor, a channel region T3A of the third transistor, and the second terminal T3D of the third transistor are all disposed on a side of the scan signal line GL away from a pixel opening region. In this way, layout space can be saved, utilization of layout space can be improved, an aperture ratio can be improved, layout design of an OLED device can be made more reasonable, and service life of the OLED device can be increased.

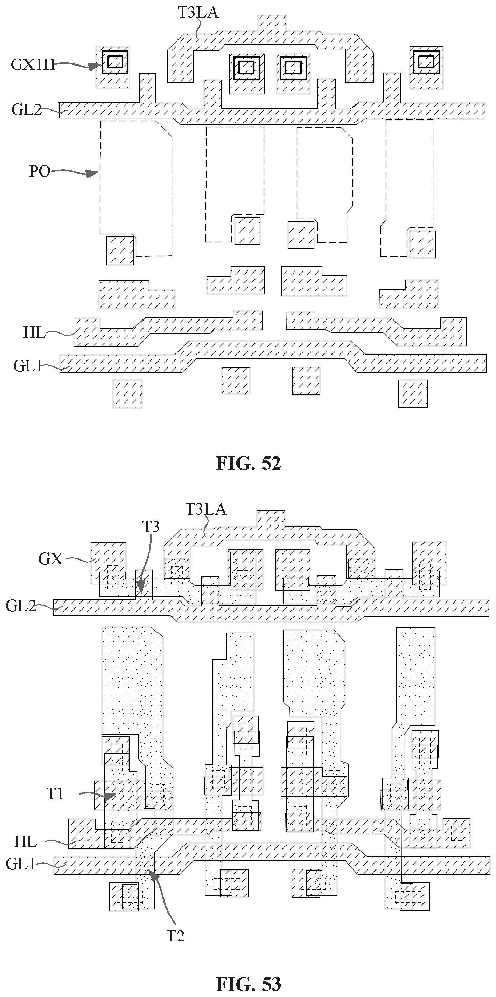

As another example, in the example of FIG. 53, a gate of the third transistor is electrically connected to a second scan signal line GL2; a first terminal of the third transistor, a channel region of the third transistor, and a second terminal of the third transistor are all disposed on the same side of the second scan signal line GL2, for example, all disposed on a side of the second scan signal line GL2 away from a pixel opening region.

In some embodiments of this disclosure, a transistor is a thin film transistor TFT, which includes a channel region CR located in a semiconductor layer SCL, and includes two conductive structures CS located on two sides of the channel region CR. It can be understood that the thin film transistor TFT further has a gate located in the second metal layer GT, and has a gate insulating structure located between the gate and the channel region (located in a gate insulating layer).

In embodiments of this disclosure, referring to FIG. 2, conductive structures CS of a thin film transistor can be selected from any one of a first conductive structure, a second conductive structure, and a third conductive structure according to requirements. Two conductive structures CS of the thin film transistor TFT may be of the same type or may be of different types.

The first conductive structure includes an electrical contact structure located in the semiconductor layer SCL, a lapping insulating structure located in the gate insulating layer GI, and a lapping structure located in the second metal layer GT. The lapping insulating structure has a lapping via hole, and the lapping structure is electrically connected to the electrical contact structure through the lapping via hole. In the first conductive structure CS, the electrical contact structure and the channel region CR are both located in the semiconductor layer SCL and are adjacently disposed, and the electrical contact structure and the channel region CR together serve as a part of an active layer of the thin film transistor TFT. The electrical contact structure may serve as a source electrode or a drain electrode of the thin film transistor, and the lapping structure is electrically connected to the electrical contact structure through the lapping via hole, so that the source electrode or the drain electrode of the transistor is electrically connected to the second metal layer.

The second conductive structure includes an electrical contact structure located in the semiconductor layer SCL, a lapping insulating structure located in the gate insulating layer GI, and a lapping structure located in the second metal layer GT. Moreover, the second conductive structure CS overlaps an inorganic buffer layer BUF and the first metal layer SHL. The lapping insulating structure has a lapping via hole, and the lapping via hole includes a main via hole that exposes the semiconductor layer SCL and a first auxiliary hole that is located outside a region of the semiconductor layer SCL and can expose the first metal layer SHL, and the main via hole and the first auxiliary hole are adjacently disposed. The inorganic buffer layer BUF has a second auxiliary hole aligned with the first auxiliary hole; the first auxiliary hole and the second auxiliary hole expose at least a part of the first metal layer SHL. The lapping structure is electrically connected to the electrical contact structure through the main via hole of the lapping via hole, and the lapping structure is electrically connected to the first metal layer SHL through the first auxiliary hole and the second auxiliary hole of the lapping via hole. In the second conductive structure CS, the electrical contact structure and the channel region CR are both located in the semiconductor layer SCL and are adjacently disposed, and the electrical contact structure and the channel region CR together serve as a part of an active layer of the thin film transistor TFT. The electrical contact structure may serve as a source electrode or a drain electrode of the thin film transistor; the lapping structure is electrically connected to the electrical contact structure through a via hole and is electrically connected to the first metal layer SHL, so that the source electrode or the drain electrode of the transistor is electrically connected to the first metal layer SHL.

The third conductive structure includes an electrical contact structure located in the semiconductor layer SCL, and the electrical contact structure does not need to be electrically connected to the second metal layer or the first metal layer through a via hole. The electrical contact structure and the channel region CR are both located in the semiconductor layer SCL and are adjacently disposed, and the electrical contact structure and the channel region CR together serve as a part of an active layer of the thin film transistor TFT.

In one embodiment of this disclosure, during fabrication of the display panel PNL, a patterned semiconductor layer SCL may be fabricated first, and then a gate insulating layer GI is fabricated. When fabricating the gate insulating layer GI, an entire gate insulating layer GI may be deposited first, and then via holes are formed in the entire gate insulating layer GI. At least some via holes expose at least part of regions of the semiconductor layer SCL. After via holes are formed in the entire gate insulating layer GI, an ion implantation method is used to conductorize exposed semiconductor layer SCL, so that regions of the semiconductor layer SCL that are exposed are conductorized, and portions of the semiconductor layer SCL covered by the gate insulating layer GI are not conductorized. Then, the second metal layer GT is fabricated. For example, an entire second metal layer GT is formed on a side of the gate insulating layer GI away from the semiconductor layer SCL, and then a photolithography process is used to pattern the entire second metal layer GT. When forming the second metal layer GT, the second metal layer GT covers part of regions of the semiconductor layer SCL exposed in the via holes formed in the entire gate insulating layer GI. Using the second metal layer GT as a mask (or using a photoresist layer defining a pattern of the second metal layer GT as a mask), the gate insulating layer GI with via holes is patterned, for example, portions of the gate insulating layer GI that are not covered by the mask (the second metal layer GT or the photoresist layer) are removed by etching. This exposes the semiconductor layer SCL that does not overlap the mask; then an ion implantation method is used to conductorize exposed semiconductor layer SCL to form a conductive channel. In this process, the channel region CR of the transistor is protected by the gate of the transistor, so semiconductor characteristics are maintained.

During the process of patterning the gate insulating layer GI by using the second metal layer GT as a mask, exposed regions of the semiconductor layer SCL that are not covered by the gate insulating layer GI may be damaged during etching, for example, portions of the semiconductor layer SCL that are not covered by the gate insulating layer GI may be thinned or even locally etched through. Therefore, thickness of the semiconductor layer SCL in regions not covered by the gate insulating layer GI may be smaller than thickness of the semiconductor layer SCL in the channel region CR.

In one example, since the gate insulating layer GI is patterned by using the second metal layer GT as a mask, an orthographic projection of the gate insulating layer GI on the substrate base SBT does not extend beyond an orthographic projection of the second metal layer GT on the substrate base SBT. The second metal layer GT protects the covered gate insulating layer GI to prevent the covered gate insulating layer GI from being etched.

In embodiments of this disclosure, an insulating layer may be disposed between the second metal layer GT and a pixel electrode layer, and the insulating layer has a pixel electrode via hole; a pixel electrode is electrically connected to the second metal layer GT through the pixel electrode via hole.

As one example, when the insulating layer between the second metal layer GT and the pixel electrode layer includes a planarization layer, the planarization layer forms the pixel electrode via hole.

As another example, when the insulating layer between the second metal layer GT and the pixel electrode layer includes a planarization layer and a passivation layer, the planarization layer and the passivation layer together form the pixel electrode via hole.

In some embodiments of this disclosure, the pixel electrode via hole can be staggered with other via holes to avoid excessive depth of the pixel electrode via hole.

In some other embodiments, the pixel electrode via hole can overlap with some via holes, that is, an orthographic projection of the pixel electrode via hole on the substrate base can overlap with orthographic projections of other via holes on the substrate base, which can reduce total layout area of via holes and reduce the encroachment of the via holes on the pixel opening.

The pixel driving circuit PDC of the display panel PNL provided in embodiments of this disclosure will be described in detail below with reference to the accompanying drawings.

In one embodiment of this disclosure, referring to FIGS. 5 and 6, the third transistor T3 includes a first terminal T3S of the third transistor, a channel region T3A of the third transistor, and a second terminal T3D of the third transistor that are located in the semiconductor layer SCL, and a length direction of the channel region T3A of the third transistor is a row direction DH; the first terminal T3S of the third transistor, the channel region T3A of the third transistor, and the second terminal T3D of the third transistor are all disposed on the same side of the scan signal line GL. Further, the scan signal line GL has a scan signal line branch GLA protruding along a column direction DV, and the scan signal line branch GLA overlaps the channel region T3A of the third transistor. In other words, the scan signal line branch GLA includes a gate of the third transistor T3, and the channel region T3A of the third transistor overlaps the gate of the third transistor T3.

In one example, the length direction of the channel region T3A of the third transistor is parallel to the scan signal line GL, for example, extends along the row direction DH.

Optionally, referring to FIG. 6, a first via hole HA is provided on the first terminal T3S of the third transistor, and the first terminal T3S of the third transistor is electrically connected to the second metal layer GT through the first via hole HA; a length direction of the first via hole HA is the column direction DV. In this way, the length direction of the first via hole HA is perpendicular to the length direction of the channel region T3A of the third transistor. This can avoid an excessively large size of the third transistor T3 in the row direction DH, thereby compressing a layout area of the pixel driving circuit PDC, which is beneficial to improving an aperture ratio or improving resolution.

In one example, the first via hole HA is in an open-ended shape; specifically, the first via hole HA is a notch opened at an edge of the gate insulating layer GI, and an opening of the notch is an open end of the first via hole HA. Further, an opening direction (an orientation of the notch) of the first via hole HA is the column direction DV, and in particular, may be a direction toward the pixel opening PO.

Optionally, referring to FIG. 6, a second via hole HB is provided on the second terminal T3D of the third transistor, and the second terminal T3D of the third transistor is electrically connected to the second metal layer GT through the second via hole HB; a length direction of the second via hole HB is the column direction DV. In this way, the length direction of the second via hole HB is perpendicular to the length direction of the channel region T3A of the third transistor. This can avoid an excessively large size of the third transistor T3 in the row direction DH, thereby reducing a layout area of the pixel driving circuit PDC, which is beneficial to improving an aperture ratio or improving resolution.

In one example, the second via hole HB is in an open-ended shape; specifically, the second via hole HB is a notch opened at an edge of the gate insulating layer GI, and an opening of the notch is an open end of the second via hole HB. Further, an opening direction (an orientation of the notch) of the second via hole HB is the column direction DV, and in particular, may be a direction toward the pixel opening PO.

In one embodiment of this disclosure, referring to FIGS. 5 and 6, the display panel PNL is provided with a transfer structure T3L, and the transfer structure T3L is electrically connected to the first terminal T3S of the third transistor and is electrically connected to the sensing signal line SL. In this way, the first terminal T3S of the third transistor is electrically connected to the sensing signal line SL through the transfer structure T3L.

In the example of FIG. 6, both the first via hole HA and the second via hole HB have open ends along the column direction DV, that is, opening directions of the first via hole HA and the second via hole HB are both perpendicular to the length direction of the channel region T3A of the third transistor. It can be understood that, in other embodiments of this disclosure, one of the first via hole HA and the second via hole HB may also not be in an open-ended structure, or an opening direction may be the row direction DH.

In one embodiment of this disclosure, referring to FIG. 6, both the first via hole HA and the second via hole HB are rectangular. An opening direction of the first via hole HA is parallel to a length direction of the first via hole HA. An opening direction of the second via hole HB is parallel to a length direction of the second via hole HB. In this way, electrical connection between the second metal layer GT and the first terminal T3S of the third transistor and the second terminal T3D of the third transistor can be ensured, and contact resistance can be reduced.

In one embodiment of this disclosure, referring to FIGS. 5 to 7, the display panel PNL includes pixel driving circuit groups PDCS arranged in an array, and each pixel driving circuit group PDCS includes four pixel driving circuits PDC arranged in the same row, and the four pixel driving circuits PDC are connected to the same sensing signal line SL. In the embodiment, two pixel driving circuits PDC are located on one side of the sensing signal line SL, and the other two pixel driving circuits PDC are located on the other side of the sensing signal line SL. The display panel PNL is further provided with data signal lines DL that respectively drive the four pixel driving circuits PDC of the pixel driving circuit group PDCS; in the embodiment, two data signal lines DL are respectively disposed on two sides of the sensing signal line SL. In this way, a design layout of the pixel driving circuits PDC in the display panel PNL is achieved, such that a layout design of an OLED device is more reasonable.

In embodiments of this disclosure, if a first terminal T3S of a third transistor of one pixel driving circuit PDC is reused as a first terminal T3S of a third transistor of an adjacent pixel driving circuit PDC, the reused first terminal T3S of the third transistor is referred to as a reuse structure TX.

In embodiments of this disclosure, the pixel driving circuit group PDCS is provided with two reuse structures TX, and the two reuse structures TX are disposed on two sides of the sensing signal line SL, and the reuse structures TX are located in the semiconductor layer SCL. The reuse structures TX serve as first terminals T3S of third transistors T3 of two adjacent pixel driving circuits, and are respectively connected to channel regions T3A of the third transistors T3 of the two adjacent pixel driving circuits. In this way, an arrangement manner in which thin film transistors TFT are combined into two and then combined again can be achieved, and adjacent thin film transistors TFT share source/drain electrodes, thereby improving space utilization and improving an aperture ratio.

Optionally, two data signal lines DL located on the same side of the sensing signal line SL overlap the reuse structure TX. In this way, one-to-one driving of the pixel driving circuits PDC can be achieved, thereby reducing a spacing between two adjacent data signal lines DL and improving space utilization.

In one embodiment of this disclosure, the pixel driving circuit group PDCS respectively drives four different sub-pixels PIX of the same pixel. For example, one pixel includes four different sub-pixels PIX, for example, a red sub-pixel, a white sub-pixel, a green sub-pixel, and a blue sub-pixel; the four pixel driving circuits PDC in the pixel driving circuit group PDCS respectively drive four sub-pixels PIX of different colors. In one example, along the row direction DH, the four different sub-pixels PIX corresponding to the pixel driving circuit group PDCS are sequentially arranged in an order of a red sub-pixel, a white sub-pixel, a green sub-pixel, and a blue sub-pixel.

In one embodiment of this disclosure, referring to FIGS. 5 to 9, the transfer structure T3L corresponds to the pixel driving circuit group PDCS, the two reuse structures TX of the pixel driving circuit group PDCS are respectively electrically connected to the transfer structure T3L, and the transfer structure T3L is electrically connected to the sensing signal line SL. In this way, thin film transistors TFT after being combined into two can be electrically connected to the sensing signal line SL in a manner of being combined again, thereby reducing connection holes, reducing transverse scan signal lines GL, and saving space.

In one embodiment of this disclosure, referring to FIGS. 5 to 9, two reuse structures TX are electrically connected to the sensing signal line SL by using the transfer structure T3L, that is, four third transistors T3 in four pixel driving circuits PDC are connected to the sensing signal line SL after being combined into pairs, thereby achieving a layout design in which thin film transistors TFT are combined into two and then combined again.

In embodiments of this disclosure, the transfer structure T3L of the display panel PNL may adopt different forms according to requirements.

In one strategy, referring to FIGS. 5 and 6, the transfer structure T3L adopts a first transfer line T3LA, and the first transfer line T3LA is disposed in the same layer as the scan signal line GL. The first transfer line T3LA is electrically connected to the reuse structure TX through the first via hole HA. In this way, first terminals of four third transistors of the pixel driving circuit group PDCS are electrically connected to each other through the first transfer line T3LA. Further, the first via hole HA is located between two adjacent data signal lines DL.

Optionally, referring to FIG. 6, the first transfer line T3LA includes a first segment T3LA1 of the first transfer line extending along the row direction DH, and two second segments T3LA2 of the first transfer line that are respectively connected to two ends of the first segment T3LA1 of the first transfer line. The second segments T3LA2 of the first transfer line extend along the column direction DV; the first segment T3LA1 of the first transfer line is electrically connected to the sensing signal line SL; and the second segments T3LA2 of the first transfer line are electrically connected to the reuse structures TX. Further, the second segments T3LA2 of the first transfer line are entirely or partially located between two adjacent data signal lines DL.

Optionally, when etching a portion of the gate insulating layer GI not covered by the second metal layer GT and performing second conductorization on the underlying semiconductor layer SCL, there is a risk that a portion of the semiconductor layer SCL not covered by the second metal layer GT may be etched and damaged, causing erroneous connection between the scan signal line GL and the first metal layer SHL.

In one example, in order to avoid erroneous connection between the second metal layer GT and the first metal layer SHL, the first via hole HA cannot overlap the data signal line DL. By enabling the length direction of the first via hole HA to be the column direction DV, a size of the first via hole HA in the row direction DH can be reduced, thereby compressing a spacing between two data signal lines DL on the same side of the sensing signal line SL. This can improve space utilization.

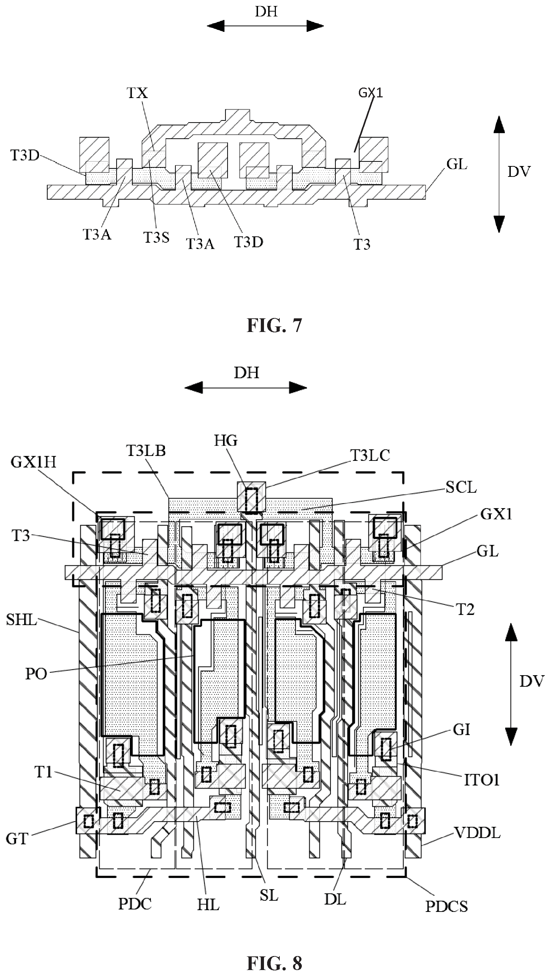

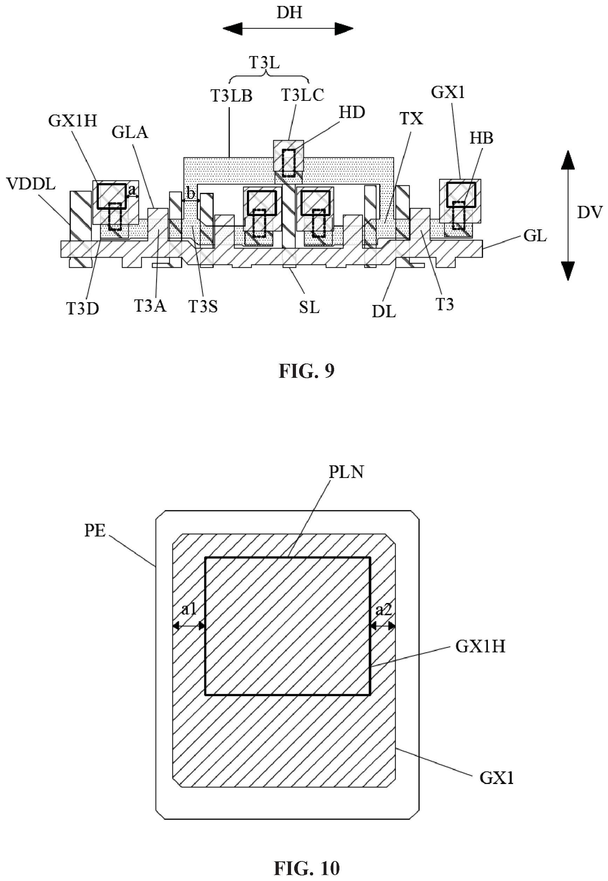

In another strategy, referring to FIGS. 8 and 9, the transfer structure T3L includes a second transfer line T3LB. The second transfer line T3LB is disposed in the same layer as the channel region T3A of the third transistor and is conductorized. The second transfer line T3LB is connected to the reuse structure TX and is electrically connected to the sensing signal line SL. In this way, the display panel PNL can avoid providing the first via hole HA, and two adjacent data signal lines DL do not need to avoid the first via hole HA, so that a spacing between two adjacent data signal lines DL can be further compressed, which is beneficial to improving an aperture ratio or improving resolution. In this strategy, a length of the second transfer line T3LB is not too long, so using conductorized semiconductor material does not cause serious voltage drop or power consumption loss.

Moreover, since the second transfer line T3LB is not disposed in the second metal layer GT, other structures in the second metal layer GT have larger layout space. For example, the second metal layer GT is provided with a first metal structure GX1, and the first metal structure GX1 is electrically connected to the second terminal T3D of the third transistor through the second via hole HB, and is electrically connected to the pixel electrode PE through the pixel electrode via hole GX1H. Among them, the second via hole HB is a via hole opened in the planarization layer PLN. It can be understood that, when the display panel PNL is provided with a passivation layer PVX, the second via hole HB further penetrates the passivation layer PVX and exposes the first metal structure GX1.

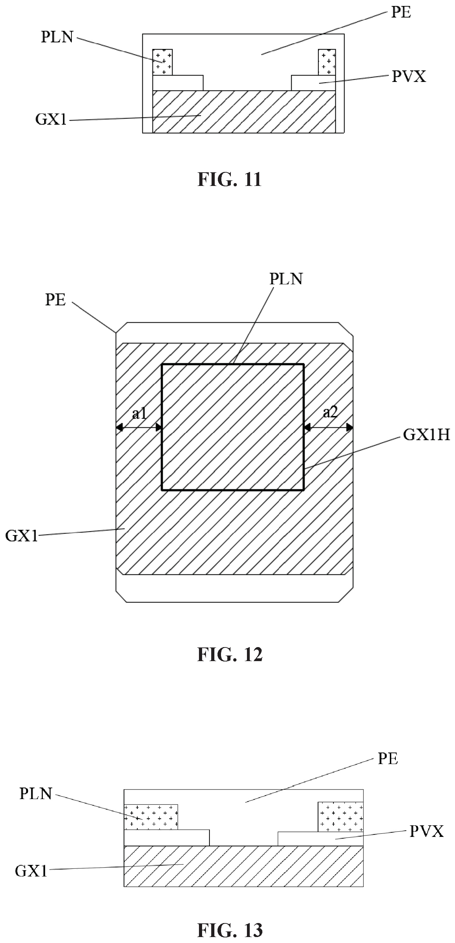

When the first strategy is adopted, the first metal structure GX1 needs to avoid other structures disposed in the same layer and is limited in size. In one example, referring to FIGS. 10 and 11, the first metal structure GX1 covers the pixel electrode via hole GX1H; along the row direction DH, sizes by which the first metal structure GX1 exceeds an edge of the pixel electrode via hole GX1H are respectively a first size a1 and a second size a2. In the embodiment, a1 is 1 to 2 micrometers, for example, 1 micrometer, 1.2 micrometers, 1.4 micrometers, 1.6 micrometers, 1.8 micrometers, or 2 micrometers; a2 is 1 to 1.5 micrometers, for example, 1 micrometer, 1.1 micrometers, 1.2 micrometers, 1.3 micrometers, 1.4 micrometers, or 1.5 micrometers. In this way, electrical connection between the first metal structure GX1 and the pixel electrode PE can be ensured.

When the second strategy is adopted, the transfer structure T3L does not encroach on the first metal structure GX1, so a size of the first metal structure GX1 can be increased. In one example, referring to FIGS. 12 and 13, the first metal structure GX1 covers the pixel electrode via hole GX1H; along the row direction DH, sizes by which the first metal structure GX1 exceeds an edge of the pixel electrode via hole GX1H are respectively a first size a1 and a second size a2. In the embodiment, both the first size a1 and the second size a2 are 2 to 3.5 micrometers. For example, the first size a1 is 2 micrometers, 2.5 micrometers, 3 micrometers, or 3.5 micrometers. For another example, the second size a2 is 2 micrometers, 2.5 micrometers, 3 micrometers, or 3.5 micrometers. Compared with the first strategy, the second strategy provides space for increasing the size of the first metal structure GX1, thereby being beneficial to improving reliability of electrical connection between the pixel electrode PE and the first metal structure GX1.

In one example, referring to FIG. 9, a length direction of the second via hole HB is the column direction DV. In this way, a size of the second via hole HB in the row direction DH can be reduced, thereby being beneficial to compressing a layout size of the pixel driving circuit PDC in the row direction DH, improving space utilization to improve an aperture ratio or improve resolution. Further, the second via hole HB is in an open-ended structure, that is, the second via hole HB extends to an edge of the gate insulating layer GI under the first metal structure GX1; in other words, the gate insulating layer GI under the first metal structure GX1 is provided with a notch serving as the second via hole HB. Optionally, an opening direction of the second via hole HB faces toward the pixel opening PO, which can enable the pixel electrode via hole GX1H to be as far away from the scan signal line GL as possible, thereby being beneficial to increasing a size of the pixel opening PO.

In one example, referring to FIGS. 8 and 9, in the second strategy, the transfer structure T3L may further include a third transfer line T3LC. The third transfer line T3LC is disposed in the same layer as the scan signal line GL, that is, is located in the second metal layer GT. The third transfer line T3LC is electrically connected to the second transfer line T3LB through a fourth via hole HD, and is electrically connected to the sensing signal line SL through a seventh via hole HG. Specifically, the fourth via hole HD crosses an edge of the second transfer line T3LB, and a first portion thereof exposes the second transfer line T3LB and a second portion thereof exposes the sensing signal line SL located in the first metal layer SHL. It can be understood that, in addition to penetrating the gate insulating layer GI, the second portion of the fourth via hole HD also penetrates the inorganic buffer layer BUF. In this way, a number of via holes can be reduced and space utilization can be improved.

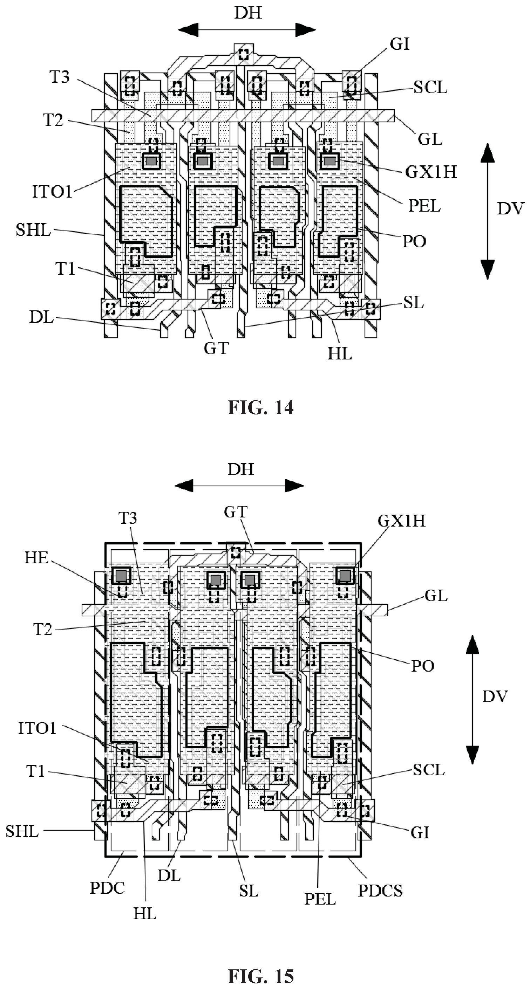

It can be understood that, in some other embodiments of this disclosure, the first terminal and the second terminal of the third transistor T3 may also be respectively disposed on two sides of the scan signal line GL, rather than on the same side. For example, in an embodiment illustrated in FIG. 14, in two adjacent third transistors T3 on the same side of the sensing signal line SL, first terminals of the two third transistors T3 are reused; however, the first terminal and the second terminal of the third transistor T3 are respectively located on two sides of the scan signal line GL. In this embodiment, the pixel electrode via hole GX1H and the pixel opening PO are located on the same side of the scan signal line GL; since a depth of the pixel electrode via hole GX1H is relatively large, the pixel definition layer PDL is difficult to sufficiently planarize a region of the pixel electrode via hole GX1H, and thus there is a risk of light leakage; compared with an embodiment in which the pixel electrode via hole GX1H and the pixel opening PO are respectively disposed on two sides of the scan signal line GL, this embodiment reduces a size of the pixel opening.

In some embodiments of this disclosure, referring to FIGS. 15, 24, and 37, the third transistor T3 is disposed on one side of the scan signal line GL, for example, a channel region, a first terminal, and a second terminal of the third transistor T3 are all disposed on a side of the scan signal line GL away from the pixel opening PO; in two adjacent pixel driving circuits PDC located on the same side of the sensing signal line SL, two third transistors T3 share the same first terminal; and two third transistors T3 sharing the same first terminal are arranged in a staggered manner, that is, channel regions T3A of the two third transistors are respectively located on two sides of the first terminal in the row direction DH. In this way, space occupied by the third transistor T3 can be reduced.

In one example, the display panel PNL is a high-PPI bottom-emission OLED display panel, and in the display panel PNL, the second transistor T2 and the third transistor T3 are both disposed laterally (a length direction of a channel region CR is the row direction DH), and the second transistor T2 and the third transistor T3 are respectively disposed on two sides of the scan signal line GL. This can reduce space occupied by thin film transistors, improve utilization of layout space, increase an aperture ratio, and increase service life of an OLED device. In other words, in this example, by enabling two third transistors T3 sharing a first terminal to be laterally arranged on one side of the scan signal line GL, the display panel PNL can improve space utilization and reduce a layout area of the pixel driving circuit PDC while satisfying layout space and process requirements, thereby increasing an aperture ratio of the display panel PNL.

In a first embodiment of this disclosure, referring to FIGS. 15 to 17, a pixel opening PO of a sub-pixel PIX driven by at least one pixel driving circuit PDC and the third transistor T3 of the pixel driving circuit PDC are respectively located on two sides of the scan signal line GL. In this way, a relatively large distance between the pixel opening PO and the pixel electrode via hole GX1H in the pixel driving circuit PDC can be ensured, thereby avoiding the pixel electrode via hole GX1H from encroaching on the pixel opening PO, which is beneficial to improving an aperture ratio.

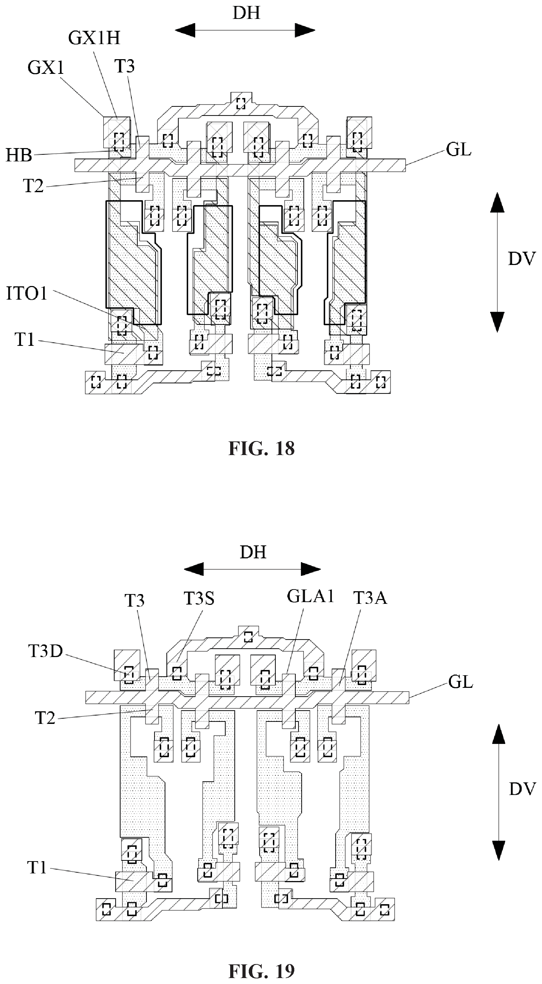

In the first embodiment of this disclosure, referring to FIGS. 15, 16, and 18, the second metal layer GT has a first metal structure GX1, the first metal structure GX1 is electrically connected to the second electrode plate CST2 of the storage capacitor (located in the transparent conductive layer ITO1) through a fifth via hole HE (referring to FIG. 15), and the first metal structure GX1 is further electrically connected to the second terminal T3D of the third transistor through the second via hole HB. The planarization layer PLN has a pixel electrode via hole GX1H that exposes at least a partial region of the first metal structure GX1, and the pixel electrode via hole GX1H and the pixel opening PO are respectively located on two sides of the scan signal line GL. In this way, a sufficiently large distance between the pixel electrode via hole GX1H and the pixel opening PO can be ensured, which is beneficial to increasing an aperture ratio.

In one example, the second via hole HB penetrates the gate insulating layer GI; the fifth via hole HE sequentially penetrates the gate insulating layer GI and the inorganic buffer layer BUF, and the fifth via hole HE is adjacent to and communicates with the second via hole HB.

In the first embodiment of this disclosure, referring to FIGS. 15, 16, and 19, a length direction of the channel region T3A of the third transistor is the row direction DH; the first terminal T3S of the third transistor is electrically connected to the second metal layer GT through the first via hole HA, and the second terminal T3D of the third transistor is electrically connected to the second metal layer GT through the second via hole HB. Length directions of the first via hole HA and the second via hole HB are both the column direction DV. The scan signal line GL has a first scan signal line branch GLA1 protruding along the column direction DV toward a side away from the pixel opening PO; the first scan signal line branch GLA1 includes a gate of the third transistor T3, and the channel region of the third transistor T3 overlaps the gate of the third transistor. In this way, on one hand, the third transistor T3 is disposed laterally (along the row direction DH), which facilitates two adjacent third transistors T3 sharing a first terminal and improves space utilization. On the other hand, connection between the third transistor T3 and the scan signal line GL can be achieved, thereby saving layout space.

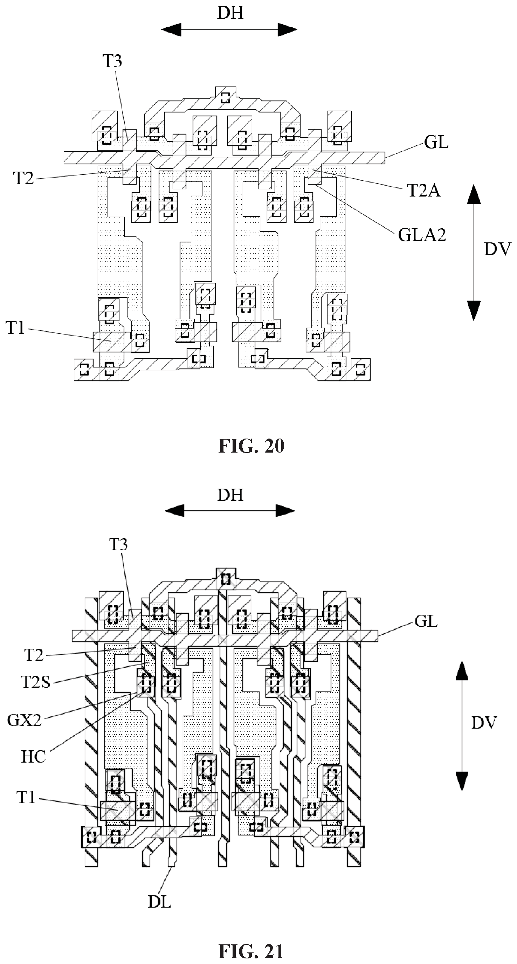

Optionally, referring to FIGS. 15, 16, and 20, the second transistor T2 and the third transistor T3 are respectively disposed on two sides of the scan signal line GL. The second transistor T2 includes an active layer located in the semiconductor layer SCL; the active layer of the second transistor T2 includes a first terminal, a channel region, and a second terminal that are sequentially connected. A channel region T2A of the second transistor has a length direction that is the row direction DH; the scan signal line GL has a second scan signal line branch GLA2 protruding along the column direction DV, the second scan signal line branch GLA2 includes a gate of the second transistor T2, and the gate of the second transistor T2 overlaps the channel region T2A of the second transistor. In this way, connection between the second transistor T2 and the scan signal line GL can be achieved, and saving of layout space can be facilitated.

In the first embodiment of this disclosure, referring to FIGS. 15, 16, and 21, the second metal layer GT has a second metal structure GX2, and the second metal structure GX2 is electrically connected to the data signal line DL through a third via hole HC and is electrically connected to the first terminal T2S of the second transistor through a sixth via hole HF. Further, the third via hole HC and the sixth via hole HF communicate with each other and form an integral via hole. In this way, electrical connection between the data signal line DL and the second transistor T2 can be achieved.

Optionally, the third via hole HC sequentially penetrates the gate insulating layer GI and the inorganic buffer layer BUF and is electrically connected to the data signal line DL (located in the first metal layer SHL); the sixth via hole HF penetrates the gate insulating layer GI and is electrically connected to the first terminal T2S of the second transistor; and ends of the third via hole HC and the sixth via hole HF that are close to each other communicate with each other.

Further, the second terminal T3D of the third transistor is electrically connected to the second terminal of the first transistor through the transparent conductive layer ITO1.

In the first embodiment of this disclosure, referring to FIGS. 15, 16, and 22, the first terminal T2S of the second transistor extends along the column direction DV; an orthographic projection of the first terminal T2S of the second transistor in the column direction DV partially overlaps an orthographic projection of the pixel opening PO in the column direction DV. An end of the first terminal T2S of the second transistor away from the channel region T2A of the second transistor is electrically connected to the data signal line DL through the second metal structure GX2. In this way, the channel region T2A of the second transistor can be located close to the scan signal line GL, improving space utilization and further increasing an aperture ratio.

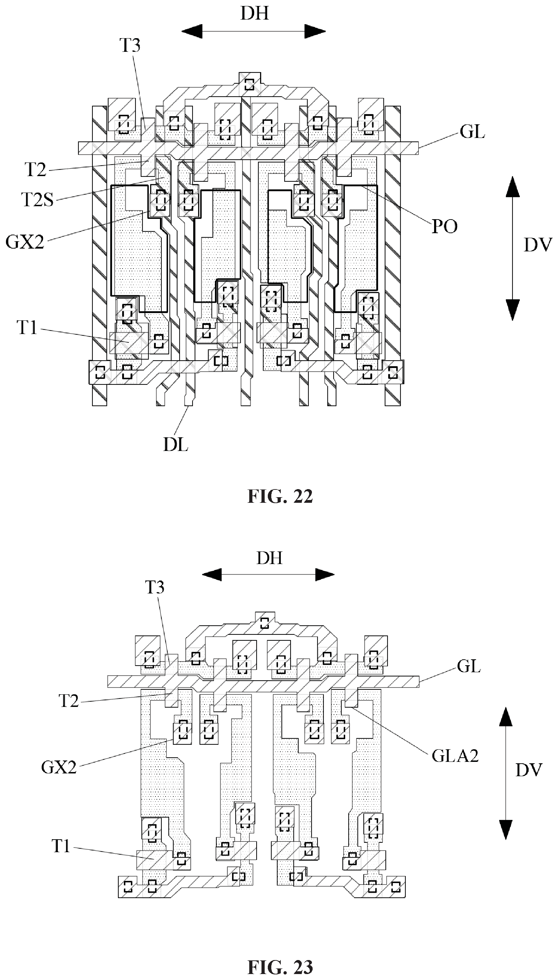

In this embodiment, referring to FIG. 22, an end of the first terminal T2S of the second transistor is away from the scan signal line GL, which causes a distance between the channel region T2A of the second transistor and the second metal structure GX2 to be relatively long, that is, the first terminal T2S of the second transistor is relatively long and plays a routing role.

In the first embodiment of this disclosure, optionally, referring to FIGS. 15, 16, and 23, the scan signal line GL has a second scan signal line branch GLA2 protruding along the column direction DV, and there is a gap between an orthographic projection of the second scan signal line branch GLA2 in the column direction DV and an orthographic projection of the second metal structure GX2 in the column direction DV. In this way, interference between the second scan signal line branch GLA2 and the second metal structure GX2 can be avoided.

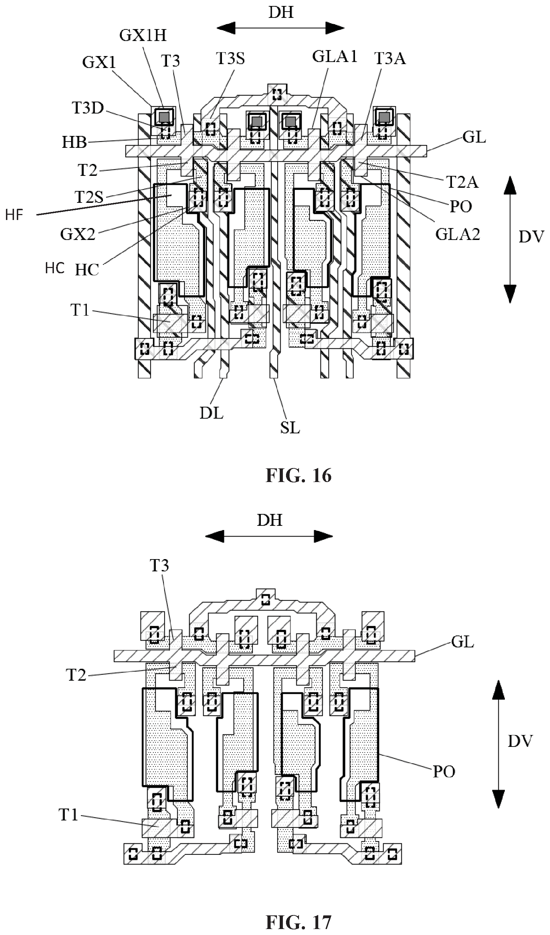

In this embodiment, optionally, referring to FIG. 16, a first avoidance notch recessed inward is provided at an end of the pixel opening PO close to the second metal structure GX2. The first avoidance notch avoids the second metal structure GX2, in particular avoids via holes connected to the second metal structure GX2. It can be understood that, if the display panel PNL is a top-emission display panel, the pixel opening PO may not be provided with the first avoidance notch.

In this embodiment, referring to FIG. 17, a second avoidance notch recessed inward is provided at an end of the pixel opening PO close to the first transistor T1, and the second avoidance notch is used to avoid via holes, avoid light leakage, and improve display quality of the display panel.

It can be understood that the display panel in embodiments of this disclosure is not limited to descriptions of the above embodiments. Structures and features of the embodiments of this disclosure may also be adjusted to achieve similar or better effects.

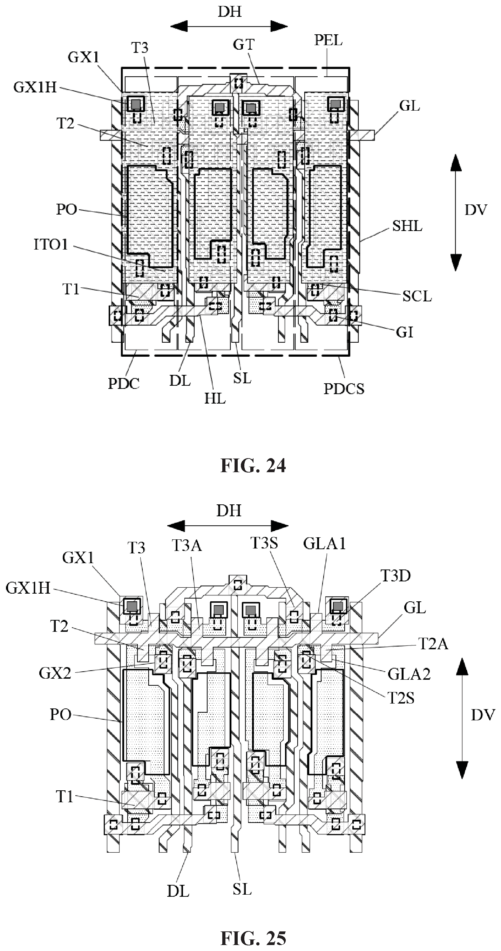

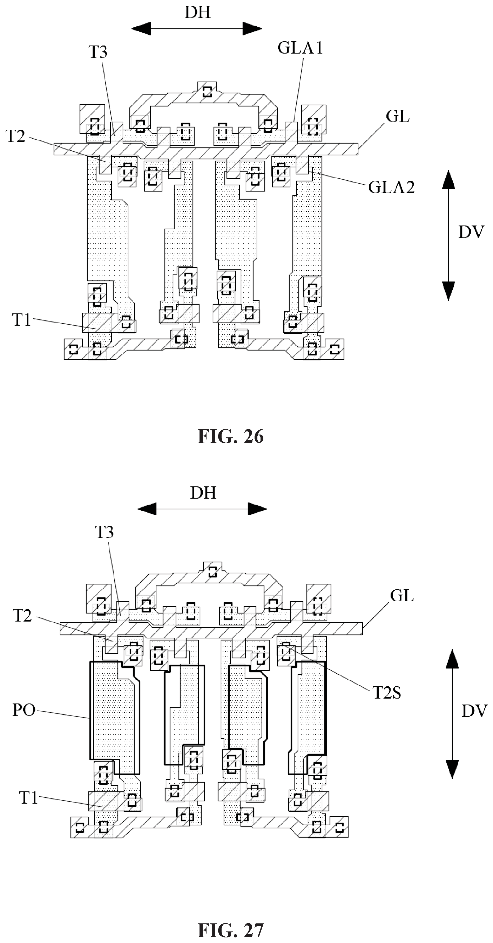

In a second embodiment of this disclosure, FIGS. 24 to 26 illustrate the second embodiment of this disclosure. In the second embodiment, the scan signal line GL has a first scan signal line branch GLA1 protruding along the column direction DV and a second scan signal line branch GLA2 protruding along the column direction DV, and the first scan signal line branch GLA1 and the second scan signal line branch GLA2 are respectively located on two sides of the scan signal line GL. Along the row direction DH, the first scan signal line branch GLA1 is located between the second scan signal line branch GLA2 and the data signal line DL. In this way, the first scan signal line branch GLA1 and the second scan signal line branch GLA2 are arranged in a staggered manner, so that the second transistor T2 and the third transistor T3 are arranged in a staggered manner on two sides of the scan signal line GL, thereby reducing space occupied by thin film transistors TFT and increasing the aperture.

Compared with the first embodiment, in the second embodiment, a spacing between the channel region T2A of the second transistor and the data signal line DL is increased, so that the second metal structure GX2 can be disposed close to the scan signal line GL, thereby avoiding the second metal structure GX2 being far away from the scan signal line GL and occupying a large amount of space.

In one example, referring to FIGS. 24, 25, and 27, an orthographic projection of the first terminal T2S of the second transistor in the column direction DV does not overlap an orthographic projection of the pixel opening PO in the column direction DV. In this way, a length of the first terminal T2S of the second transistor between the channel region T2A of the second transistor and the second metal structure GX2 can be reduced, thereby reducing a distance of the semiconductor layer SCL connecting the data signal line DL and the channel region T2A of the second transistor, and reducing impedance. At the same time, an end of the first terminal T2S of the second transistor is closer to the scan signal line GL, which is beneficial to reducing an area of the second transistor T2 and enables thin film transistors TFT to be arranged more compactly, thereby being beneficial to improving an aperture ratio.

In one example, referring to FIGS. 24, 25, and 28, an orthographic projection of the second scan signal line branch GLA2 in the column direction DV partially overlaps an orthographic projection of the second metal structure GX2 in the column direction DV.

In one example, referring to FIG. 24, an end of the pixel opening PO close to the second metal structure GX2 is provided with a third avoidance notch recessed inward, and the third avoidance notch avoids via holes connected to the second metal structure GX2. Compared with the first embodiment, the second metal structure GX2 in this example is closer to the scan signal line GL, so via holes connected to the second metal structure GX2 are closer to the scan signal line GL, which enables a size of the third avoidance notch to be smaller than that of the first avoidance notch, thereby increasing a size of the pixel opening.

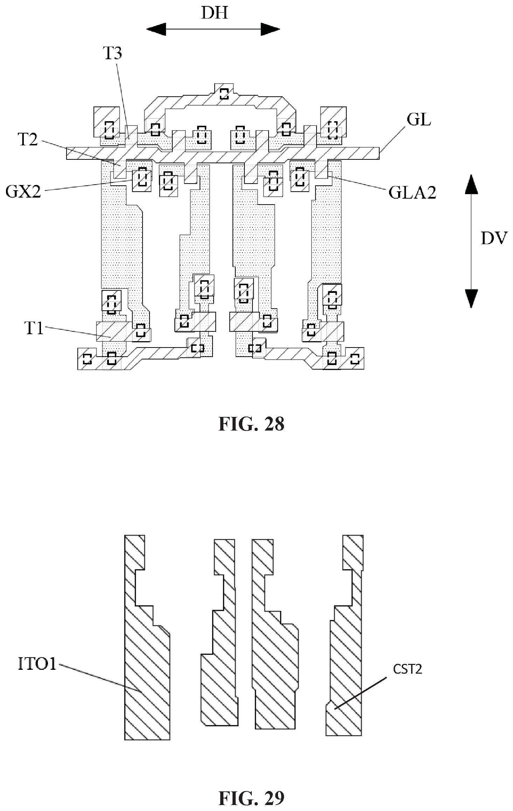

FIG. 29 illustrates a schematic structural diagram of the transparent conductive layer ITO1 in the second embodiment. The transparent conductive layer ITO1 is formed with a second electrode plate CST2 of a storage capacitor. One end of the second electrode plate CST2 of the storage capacitor is electrically connected to the first metal structure GX1 through a fifth via hole HE, and the other end is electrically connected to a second terminal of the first transistor.

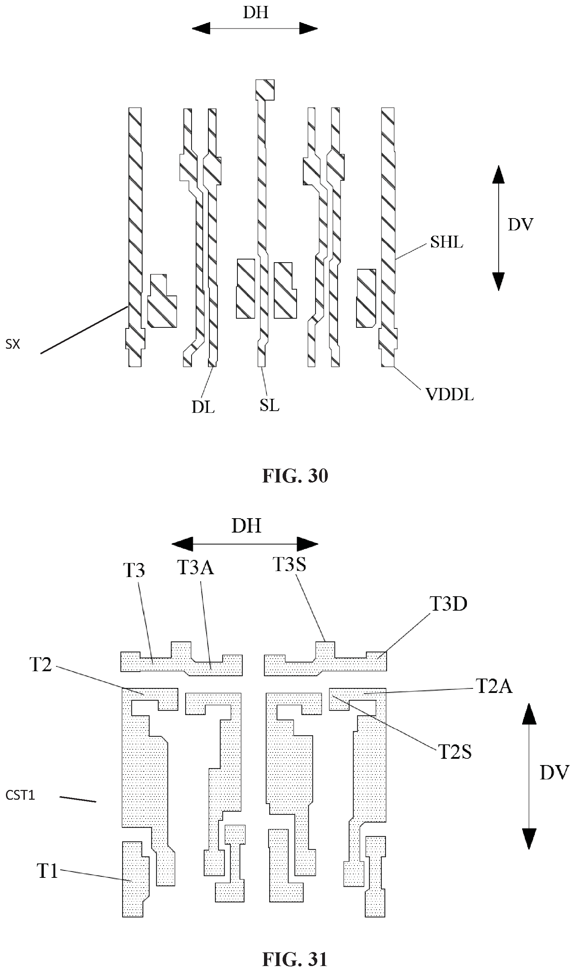

FIG. 30 illustrates a schematic structural diagram of the first metal layer SHL in the second embodiment. The first metal layer SHL is formed with a data signal line DL, a driving power voltage signal line VDDL, and a sensing signal line SL. In this way, the display panel PNL does not need to be provided with a source-drain metal layer, thereby reducing thickness and manufacturing cost of the display panel PNL. Further, the first metal layer SHL is further formed with a light-shielding portion SX, and the light-shielding portion SX overlaps a channel region of the first transistor T1 to shield light irradiating the channel region of the first transistor T1. Further, an orthographic projection of the channel region of the first transistor T1 on the substrate base SBT is completely located within an orthographic projection of the light-shielding portion SX on the substrate base SBT. Further, an orthographic projection of an active layer of the first transistor T1 on the substrate base SBT is completely located within an orthographic projection of the light-shielding portion SX on the substrate base SBT.

FIG. 31 illustrates a schematic structural diagram of the semiconductor layer SCL in the second embodiment. The semiconductor layer SCL is formed with active layers of respective thin film transistors TFT. An active layer of any thin film transistor TFT includes a first terminal, a channel region, and a second terminal that are sequentially connected. Further, the semiconductor layer SCL is further formed with a first electrode plate CST1 of a storage capacitor, and the first electrode plate CST1 of the storage capacitor is directly connected to a second terminal of the second transistor T2.

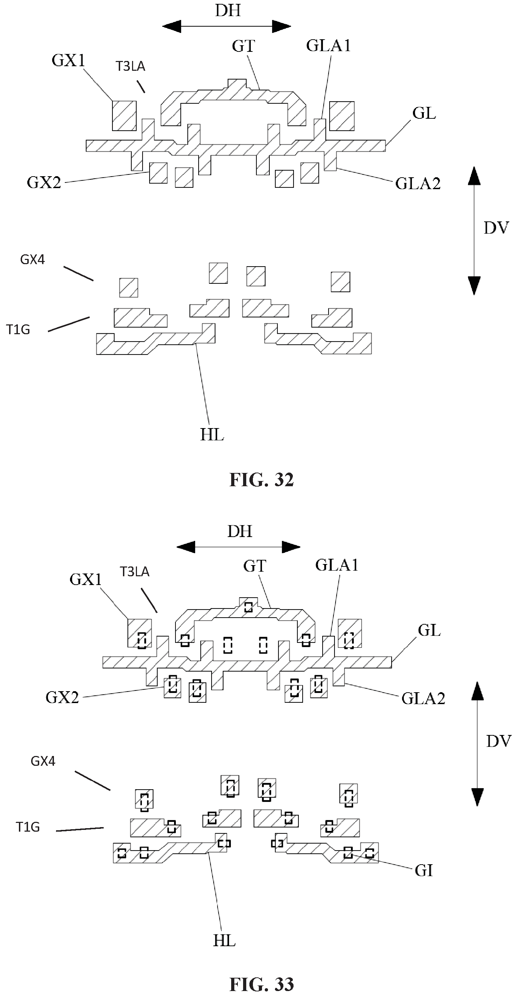

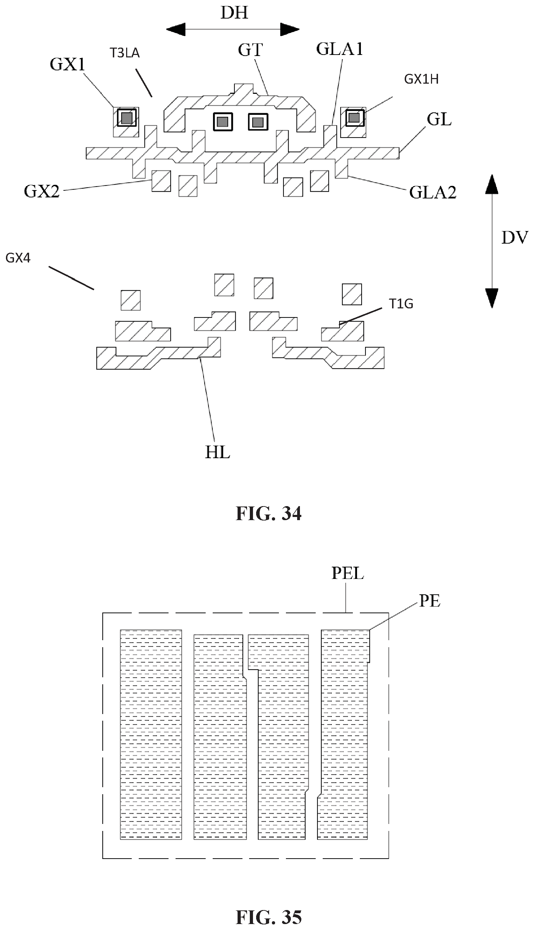

FIG. 32 illustrates a schematic structural diagram of the second metal layer GT in the second embodiment. FIG. 33 illustrates a schematic diagram showing positional relationships between the second metal layer GT and via holes covered thereby in the second embodiment. FIG. 34 illustrates a schematic diagram showing positional relationships between via holes exposing the second metal layer GT and the second metal layer GT in the second embodiment. Referring to FIG. 32, the second metal layer GT has a scan signal line GL, a first metal structure GX1, and a second metal structure GX2, and further has a first transfer line T3LA enabling a first terminal T3S of a third transistor to be electrically connected to the sensing signal line SL.

The second metal layer GT is further provided with a lateral transfer line HL extending along the row direction DH. The lateral transfer line HL is electrically connected to the driving power voltage signal line VDDL through via holes, and is electrically connected to a first terminal of at least one first transistor T1. Further, two pixel driving circuits PDC are respectively disposed on two sides of each driving power voltage signal line VDDL, and the four pixel driving circuits PDC are arranged in the same row. Each lateral transfer line HL is electrically connected to first terminals of third transistors T3 of the four pixel driving circuits PDC.

The second metal layer GT is further provided with a gate T1G of the first transistor, and the gate T1G of the first transistor overlaps a channel region of the first transistor T1. The gate of the first transistor T1 is further electrically connected to the first electrode plate CST1 of the storage capacitor through a via hole.

The second metal layer GT is further provided with a fourth metal structure GX4. The fourth metal structure GX4 is electrically connected to a second terminal of the first transistor T1 through a via hole, and is electrically connected to the second electrode plate CST2 of the storage capacitor through a via hole.

Referring to FIG. 33, via holes (for example, a first via hole HA, a second via hole HB, and the like) are provided in the gate insulating layer GI and the inorganic buffer layer BUF, and the second metal layer GT covers these via holes to electrically connect the second metal layer GT with the semiconductor layer SCL, the first metal layer SHL, and the like.

Referring to FIG. 34, pixel electrode via holes GX1H are provided in both the passivation layer PVX and the planarization layer PLN. The pixel electrode via holes GX1H are used for electrical connection between pixel electrodes PE and the first metal structure GX1.

FIG. 35 illustrates a schematic structural diagram of the pixel electrode layer PEL in the second embodiment. Referring to FIG. 35, the pixel electrode layer PEL is provided with pixel electrodes PE of the display panel PNL, and the pixel electrodes PE are electrically connected to the first metal structure GX1 through the pixel electrode via holes GX1H.

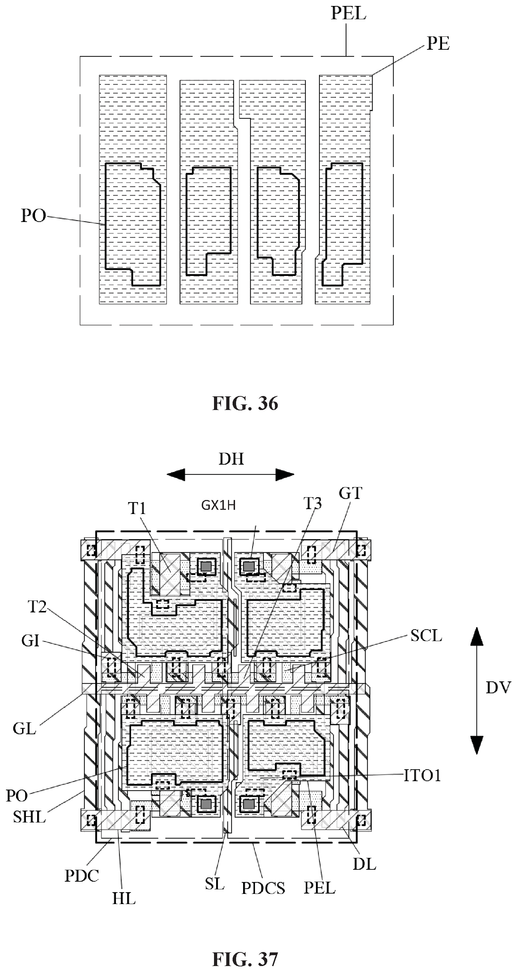

FIG. 36 illustrates a schematic structural diagram of pixel openings PO in the second embodiment. The pixel openings PO are formed in the pixel definition layer PDL to expose partial regions of the pixel electrodes PE. In the first embodiment (as shown in FIG. 15) and the second embodiment (as shown in FIG. 24) of this disclosure, each pixel driving circuit group PDCS includes four pixel driving circuits PDC arranged in the same row, and the four pixel driving circuits PDC are connected to the same sensing signal line SL. Two pixel driving circuits PDC are located on one side of the sensing signal line SL, and the other two pixel driving circuits PDC are located on the other side of the sensing signal line SL. Pixel openings PO of four sub-pixels PIX corresponding to the pixel driving circuit group PDCS are all located on the same side of the scan signal line GL.

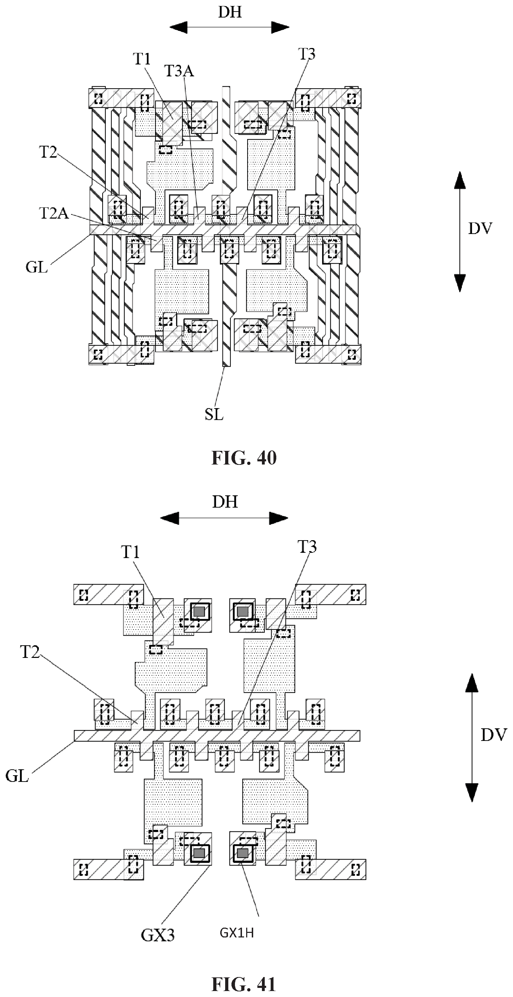

It can be understood that, in embodiments of this disclosure, arrangement of pixel driving circuits PDC is not limited thereto. For example, in a third embodiment of this disclosure, referring to FIGS. 37 to 42, each pixel driving circuit group PDCS includes four pixel driving circuits PDC connected to the same sensing signal line SL. Two pixel driving circuits PDC are located on one side of the sensing signal line SL, and the other two pixel driving circuits PDC are located on the other side of the sensing signal line SL. Two pixel driving circuits PDC are located on one side of the scan signal line GL, and the other two pixel driving circuits PDC are located on the other side of the scan signal line GL. In this way, in embodiments of this disclosure, four sub-pixels PIX are arranged in two rows and two columns. Each scan signal line GL can simultaneously drive two rows of pixel driving circuits PDC, thereby reducing a number of scan signal lines GL, being beneficial to reducing sizes of pixel driving circuits PDC in the column direction DV, reducing an aspect ratio of height (size in the column direction) to width (size in the row direction) of pixel driving circuits PDC, overcoming a decrease in space utilization caused by excessively elongated layout regions of pixel driving circuits PDC, and being beneficial to increasing sizes of pixel openings and improving resolution.

In one example of the third embodiment, referring to FIGS. 37 to 39, the second transistor T2 and the third transistor T3 of the same pixel driving circuit PDC are disposed on the same side of the scan signal line GL. The scan signal line GL has a first scan signal line branch GLA1 and a second scan signal line branch GLA2 protruding along the column direction DV. The first scan signal line branch GLA1 is provided with a gate of the third transistor T3 and overlaps the channel region T3A of the third transistor. The second scan signal line branch GLA2 is provided with a gate of the second transistor T2 and overlaps the channel region T2A of the second transistor. In a region where a pixel driving circuit PDC is located, protruding directions of the first scan signal line branch GLA1 and the second scan signal line branch GLA2 are both toward the pixel opening PO. In other words, in this embodiment, both the second transistor T2 and the third transistor T3 are disposed between the scan signal line GL and the pixel opening PO.

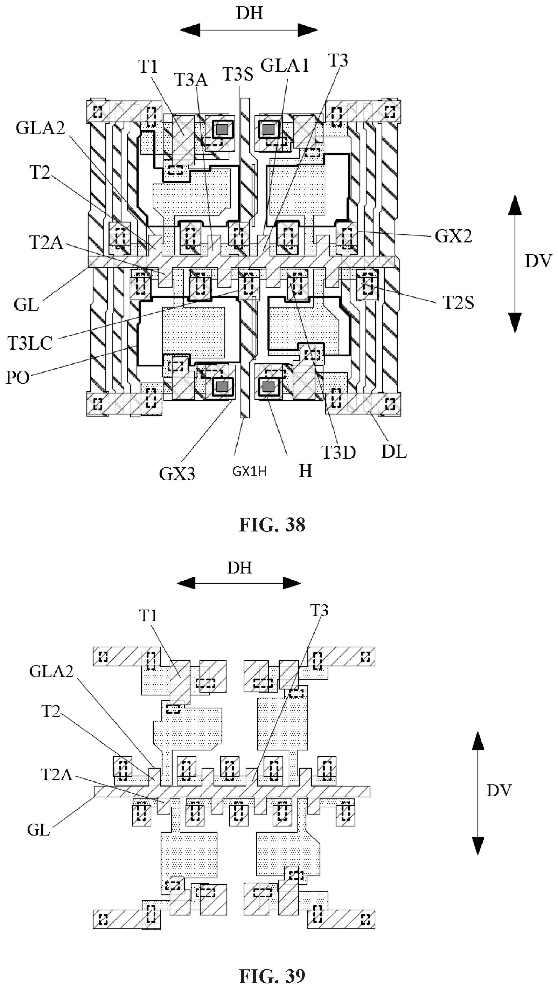

In the third embodiment, referring to FIGS. 37 and 38, the first transistor T1 is disposed on a side of the second transistor T2 away from the scan signal line GL. Two first transistors T1 adjacent along the column direction DV share a first terminal. In other words, in two first transistors T1 adjacent along the column direction DV, a first terminal of one first transistor T1 is reused as a first terminal of the adjacent first transistor T1. In this way, space occupied by thin film transistors TFT can be further reduced and an aperture ratio can be increased.

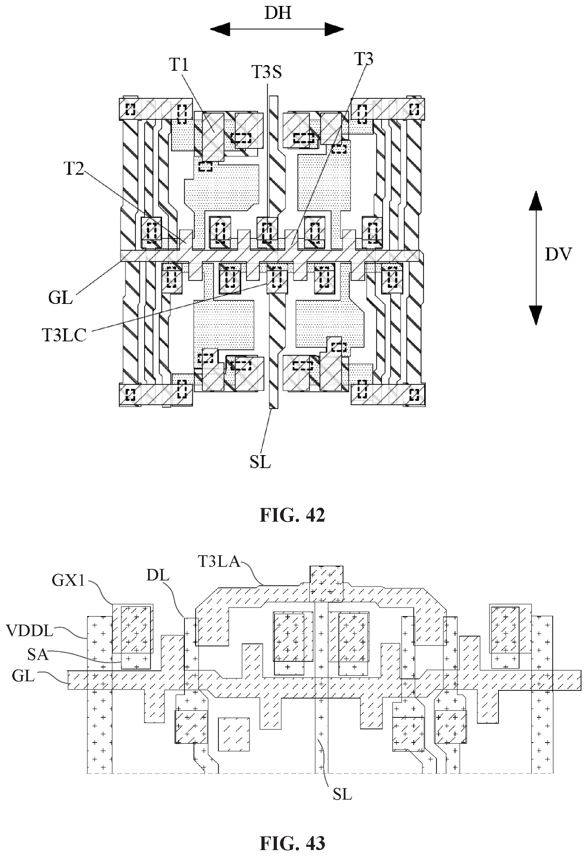

In one example of the third embodiment, referring to FIGS. 37, 38, and 40, the channel region T2A of the second transistor and the channel region T3A of the third transistor are arranged along the row direction DH. The channel region T2A of the second transistor is located on a side of the channel region T3A of the third transistor away from the sensing signal line SL. In this way, two third transistors T3 adjacent in the same row on two sides of the sensing signal line SL can share a first terminal, and the shared first terminal can be electrically connected to the sensing signal line SL through a transfer structure T3L disposed in the second metal layer GT. This is beneficial to reducing a number of via holes, thereby being beneficial to improving an aperture ratio. For example, referring to FIG. 42, third transfer lines T3LC corresponding to the sensing signal line SL are respectively disposed on two sides of the scan signal line GL. First terminals T3S of two third transistors located on the same side of the scan signal line GL are both electrically connected to the sensing signal line SL through the third transfer line T3LC on the same side. In this way, two thin film transistors TFT can be connected to the sensing signal line SL through one via hole, thereby reducing connection holes and improving space utilization.

In one example of the third embodiment, referring to FIGS. 37, 38, and 41, the second metal layer GT has a third metal structure GX3. The third metal structure GX3 is electrically connected to the second electrode plate CST2 of the storage capacitor through a via hole, and is electrically connected to the second terminal of the first transistor T1 through a via hole. The planarization layer PLN has a pixel electrode via hole GX1H exposing at least a partial region of the third metal structure GX3. The pixel electrode via hole GX1H and the pixel opening PO are located on the same side of the scan signal line GL. Further, the pixel electrode via hole GX1H and the channel region of the first transistor T1 are arranged in the same row and are both located on a side of the pixel opening PO away from the scan signal line GL. In this way, the pixel electrode via hole GX1H is prevented from being disposed between the transistor and the pixel opening PO and affecting an aperture ratio.

In one example of the third embodiment, referring to FIG. 37, an end of the pixel opening PO close to a second terminal of the second transistor T2 is provided with a fourth avoidance notch recessed inward, and an end of the pixel opening PO close to a second terminal T3D of the third transistor is provided with a fifth avoidance notch recessed inward. The fourth avoidance notch and the fifth avoidance notch are used to avoid via holes, reduce a risk of light leakage caused by via holes, and improve display quality of the display panel PNL. Since the second transistor T2 and the third transistor T3 are arranged in the same row, sizes of the fourth avoidance notch and the fifth avoidance notch are both relatively small, which is beneficial to increasing a size of the pixel opening.

The inventors further tested aperture ratios of display panels PNL in different examples. Test results show that an average aperture ratio of the display panel PNL illustrated in FIG. 14 is 15.8%, an average aperture ratio of the display panel PNL of the first embodiment is 24.8%, an average aperture ratio of the display panel PNL of the second embodiment is 26.6%, and an average aperture ratio of the display panel PNL of the third embodiment is 28%. According to the test results, it can be further clarified that the third embodiment has the largest average aperture ratio.

This disclosure further provides a display panel of a fourth embodiment. Referring to FIGS. 43 to 46, the fourth embodiment has a structure layout substantially similar to that of the second embodiment. A main difference lies in that, in the fourth embodiment, the first metal layer is provided with a metal transfer portion SA at a second terminal of the third transistor, and the metal transfer portion SA is directly lapped with the second electrode plate CST2 of the storage capacitor. The first metal structure GX1 is electrically connected to the second terminal of the third transistor through the second via hole HB, and is electrically connected to the metal transfer portion SA through the fifth via hole HE. In this way, stable and reliable connection between the second terminal of the third transistor and the second electrode plate CST2 of the storage capacitor can be ensured.

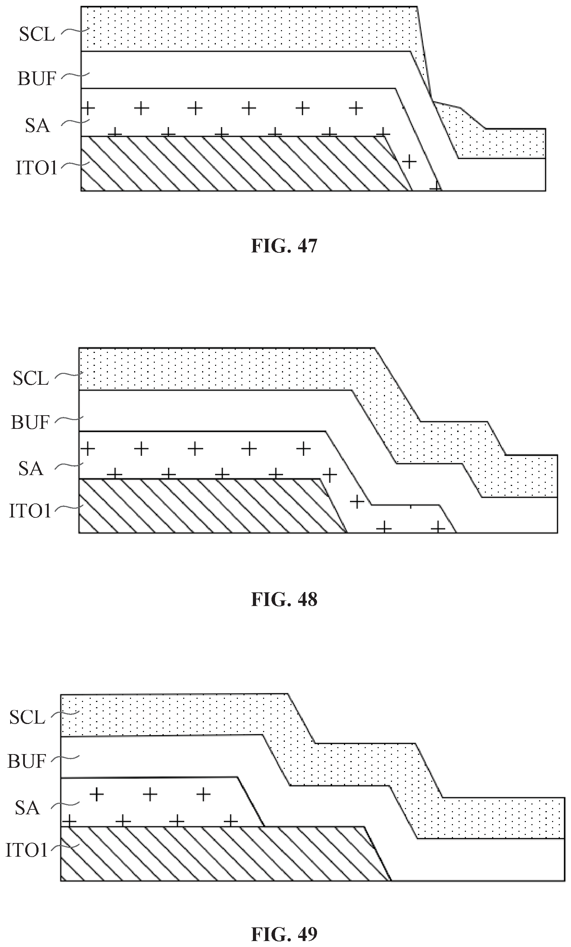

In the fourth embodiment, a portion between the second terminal of the third transistor and the channel region needs to continuously climb over the transparent conductive layer ITO1 and the first metal layer SHL. Referring to FIG. 47, at a climbing position of the semiconductor layer SCL, if an edge of the metal transfer portion SA is substantially flush with an edge of the transparent conductive layer ITO1, the semiconductor layer SCL is prone to disconnection defects. Therefore, in the fourth embodiment of this disclosure, edges of the metal transfer portion SA and the transparent conductive layer ITO1 at the climbing position of the semiconductor layer SCL can be made misaligned. In one example, referring to FIG. 48, at the climbing position of the semiconductor layer SCL, the metal transfer portion SA can cover the edge of the transparent conductive layer ITO1. In another example, referring to FIG. 49, at the climbing position of the semiconductor layer SCL, the transparent conductive layer ITO1 can extend beyond the edge of the metal transfer portion SA. In this way, the semiconductor layer SCL climbs in a stepped manner at the climbing position, thereby greatly reducing a risk of disconnection.

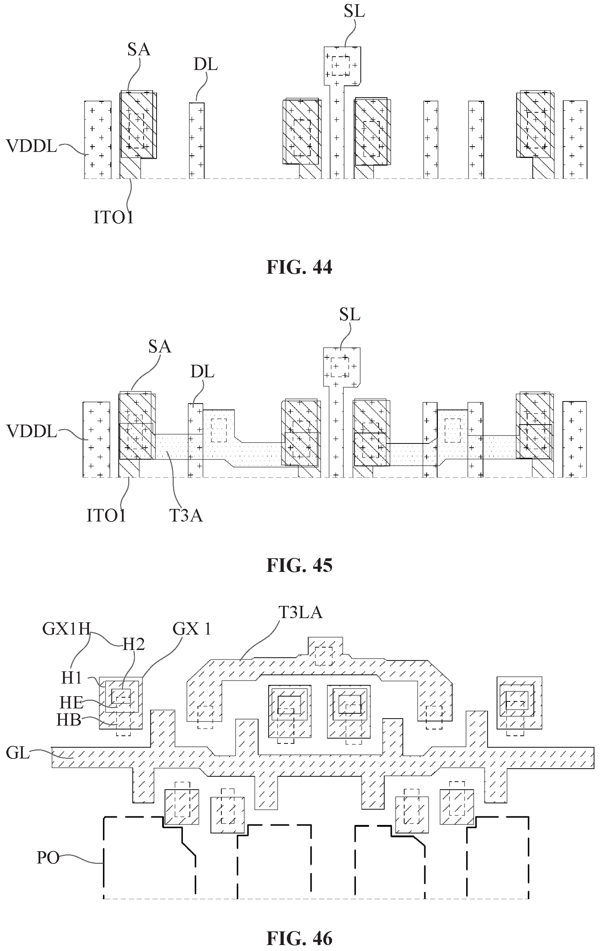

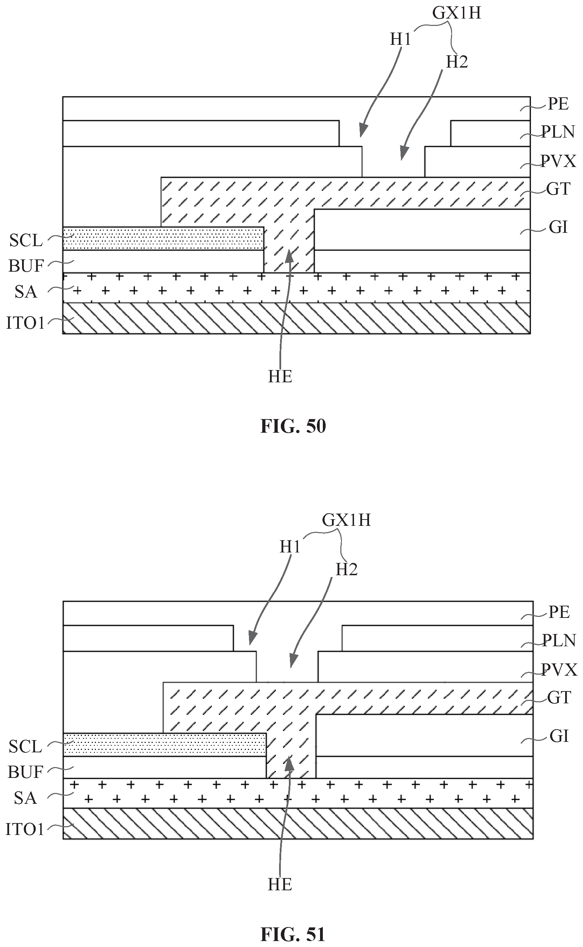

In examples of the first embodiment to the third embodiment of this disclosure, the pixel electrode via hole GX1H and other via holes are arranged in a staggered manner, as shown in FIG. 50, to avoid an excessive depth of the pixel electrode via hole GX1H. However, embodiments of this disclosure are not limited thereto. The pixel electrode via hole GX1H may also overlap with other via holes. For example, an orthographic projection of the pixel electrode via hole on the substrate base overlaps at least one of an orthographic projection of the fifth via hole on the substrate base and an orthographic projection of the second via hole on the substrate base, so as to further reduce layout area occupied by via holes. For example, in the fourth embodiment of this disclosure, referring to FIGS. 46 and 51, the pixel electrode via hole GX1H overlaps the fifth via hole HE.

Further, referring to FIG. 51, the display panel is sequentially provided with a passivation layer PVX (configured to protect the second metal layer GT) and a planarization layer PLN on a side of the second metal layer GT away from the substrate base SBT. The pixel electrode via hole GX1H sequentially penetrates the planarization layer PLN and the passivation layer PVX, and includes a first sub-hole H1 formed by the planarization layer PLN and a second sub-hole H2 formed by the passivation layer PVX. A size of the first sub-hole H1 is greater than a size of the second sub-hole H2, such that a step is formed in the pixel electrode via hole GX1H; this can reduce a disconnection risk of the pixel electrode PE in the pixel electrode via hole GX1H.

Further, the second sub-hole H2 can be arranged such that an orthographic projection of the second sub-hole H2 on the substrate base SBT overlaps the fifth via hole HE, so as to reduce layout space occupied by via holes.

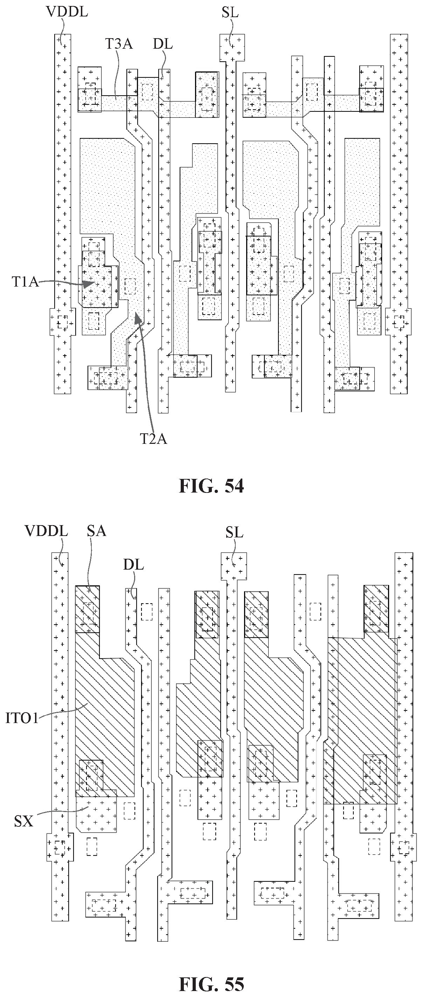

The present disclosure further provides a display panel of a fifth embodiment. Compared with the first embodiment to the fourth embodiment, a main change of the fifth embodiment lies in that, referring to FIGS. 52 to 55, a gate of the second transistor and a gate of the third transistor are respectively connected to different scan signal lines. Specifically, the scan signal lines include a first scan signal line GL1 and a second scan signal line GL2; the gate of the second transistor T2 is electrically connected to the first scan signal line GL1, and the gate of the third transistor T3 is electrically connected to the second scan signal line GL2.

In the fifth embodiment, the gate of the third transistor T3, a first terminal of the third transistor T3, and a second terminal of the third transistor T3 are all located on the same side of the second scan signal line GL2, for example, on a side of the second scan signal line GL2 away from the pixel opening PO. This can enable via holes required for electrical connection of the third transistor to be all away from the pixel opening PO, which is beneficial to reducing compression of via holes on the pixel opening PO.

As one example, referring to FIG. 53, a length direction of the third transistor is substantially parallel to an extending direction of the second scan signal line GL2, that is, extends along a row direction DH. In this way, the third transistor can be prevented from compressing the pixel opening PO in a column direction DV.

As one example, referring to FIG. 52, the pixel electrode via hole GX1H and the pixel opening PO are respectively located on two sides of the second scan signal line GL2; that is, the pixel electrode via hole GX1H is disposed close to the second terminal of the third transistor rather than close to a second terminal of the first transistor. This can reduce an influence of the pixel electrode via hole GX1H on the pixel opening PO, which is beneficial to increasing a size of the pixel opening PO.

As one example, referring to FIG. 53, the second scan signal line GL2 and the first scan signal line GL1 are respectively located on two sides of a region where the pixel opening PO is located.

Embodiments of the present disclosure further provide a display device. The display device includes any one of the display panels described in the above embodiments. The display device may be a smart phone screen, a smart watch screen, or another type of display device. Since the display device has any one of the display panels described in the above embodiments, the display device has the same beneficial effects, which are not repeated herein.

Those skilled in the art, after considering the specification and practicing the invention disclosed herein, will readily think of other embodiments of the present disclosure. This application is intended to cover any variations, uses, or adaptive changes of the present disclosure that follow the general principles of the present disclosure and include common general knowledge or conventional technical means in the art that are not disclosed in the present disclosure. The specification and embodiments are considered exemplary only, and the true scope and spirit of the present disclosure are indicated by the appended claims.

## Claims

1. A display panel, wherein the display panel comprises a substrate base, a driving layer, and a pixel layer that are sequentially stacked, the driving layer comprising a first metal layer, a semiconductor layer, a gate insulating layer, a second metal layer, and a planarization layer that are sequentially stacked on the substrate base;
wherein the driving layer comprises pixel driving circuits arranged in an array for driving the pixel layer; wherein each pixel driving circuit comprises a first transistor, a second transistor, a third transistor, and a storage capacitor, and each transistor comprises a gate, a first terminal, and a second terminal; and
wherein the display panel comprises a scan signal line, and the gate of the third transistor, and the first terminal and the second terminal of the third transistor are all located on a same side of the scan signal line.

2. The display panel according to claim 1, wherein a pixel opening of a sub-pixel driven by the pixel driving circuit and the third transistor of the pixel driving circuit are respectively located on two sides of the scan signal line.

3. The display panel according to claim 1, wherein the second metal layer comprises a first metal structure, the first metal structure being electrically connected to a second electrode plate of the storage capacitor through a fifth via hole, and the first metal structure being electrically connected to the second terminal of the third transistor through a second via hole; the driving layer further comprises a transparent conductive layer, and the second electrode plate of the storage capacitor is located in the transparent conductive layer; and
the planarization layer comprises a pixel electrode via hole exposing at least a partial region of the first metal structure, wherein the pixel electrode via hole and the pixel opening are respectively located on two sides of the scan signal line.

4. The display panel according to claim 1, wherein the third transistor further comprises a channel region of the third transistor located in the semiconductor layer, a length direction of the channel region of the third transistor is a row direction; the first terminal of the third transistor is electrically connected to the second metal layer through a first via hole, and the second terminal of the third transistor is electrically connected to the second metal layer through a second via hole; a length direction of the first via hole and a length direction of the second via hole are both a column direction; and
the scan signal line is extended along the row direction, and the scan signal line comprises a first scan signal line branch protruding along the column direction toward a side away from the pixel opening; the first scan signal line branch comprises the gate of the third transistor, and the channel region of the third transistor is overlapped with the gate of the third transistor.

5. The display panel according to claim 4, wherein the second transistor and the third transistor are respectively disposed on two sides of the scan signal line; the second transistor comprises a channel region of the second transistor located in the semiconductor layer, a length direction of the channel region of the second transistor being the row direction; and
the scan signal line comprises a second scan signal line branch protruding along the column direction, the second scan signal line branch comprising a gate of the second transistor, and the gate of the second transistor is overlapped with the channel region of the second transistor.

6. The display panel according to claim 1, wherein the scan signal line is located in the second metal layer.

7. The display panel according to claim 1, wherein the display panel comprises a data signal line, the data signal line being located in the first metal layer; and
the second metal layer comprises a second metal structure, the second metal structure being electrically connected to the data signal line through a third via hole and electrically connected to the first terminal of the second transistor through a sixth via hole.

8. The display panel according to claim 7, wherein the first terminal of the second transistor is extended along the column direction; and an orthographic projection of the first terminal of the second transistor in the column direction is partially overlapped with an orthographic projection of the pixel opening in the column direction.

9. The display panel according to claim 7, wherein the scan signal line comprises a second scan signal line branch protruding along the column direction, and a gap is present between an orthographic projection of the second scan signal line branch in the column direction and an orthographic projection of the second metal structure in the column direction.

10. The display panel according to claim 4, wherein along the row direction, the channel region of the third transistor is located between the channel region of the second transistor and the data signal line.

11. The display panel according to claim 7, wherein an orthographic projection of the first terminal of the second transistor in the column direction does not overlap an orthographic projection of the pixel opening in the column direction.

12. The display panel according to claim 7, wherein the scan signal line comprises a second scan signal line branch protruding along the column direction, and an orthographic projection of the second scan signal line branch in the column direction is at least partially overlapped with an orthographic projection of the second metal structure in the column direction.

13. The display panel according to claim 5, wherein the display panel comprises pixel driving circuit groups arranged in an array, each pixel driving circuit group comprising four pixel driving circuits disposed in a same row; the four pixel driving circuits are connected to a same sensing signal line;
wherein two of the pixel driving circuits are located on one side of the sensing signal line and other two pixel driving circuits are located on other side of the sensing signal line.

14. The display panel according to claim 1, wherein in a same pixel driving circuit, the second transistor and the third transistor are respectively disposed on a same side of the scan signal line; the scan signal line comprises a first scan signal line branch and a second scan signal line branch protruding along the column direction; the first scan signal line branch is overlapped with the channel region of the third transistor, and the channel region of the second transistor is overlapped with the second scan signal line branch.

15. The display panel according to claim 13, wherein the channel region of the second transistor and the channel region of the third transistor are arranged along the row direction; and the channel region of the second transistor is located on a side of the channel region of the third transistor away from the sensing signal line.

16. The display panel according to claim 1, wherein the display panel comprises pixel driving circuit groups arranged in an array, each pixel driving circuit group comprising four pixel driving circuits connected to a same sensing signal line;
wherein two of the pixel driving circuits are located on one side of the sensing signal line and other two pixel driving circuits are located on other side of the sensing signal line; and two of the pixel driving circuits are located on one side of the scan signal line and other two pixel driving circuits are located on other side of the scan signal line.

17. The display panel according to claim 13, wherein third transfer lines corresponding to the sensing signal line are respectively disposed on two sides of the scan signal line; and first terminals of two third transistors located on a same side of the scan signal line are both electrically connected to the sensing signal line through the third transfer line on the same side.

18. The display panel according to any one of claims 1 to 17, wherein the pixel driving circuit comprises a first transistor, a second transistor, a third transistor, and a storage capacitor, wherein a first terminal of the first transistor is electrically connected to a driving power voltage signal line for loading a driving power voltage; a first terminal of the second transistor is electrically connected to a data signal line for loading a data voltage; a first terminal of the third transistor is electrically connected to a sensing signal line;
a gate of the first transistor is electrically connected to a second terminal of the second transistor and a first electrode plate of the storage capacitor; a second terminal of the first transistor is electrically connected to a second terminal of the third transistor, a pixel electrode of the pixel layer, and a second electrode plate of the storage capacitor; and gates of the second transistor and the third transistor are respectively electrically connected to the scan signal line for loading a scan signal.

19. The display panel according to claim 1, wherein the display panel comprises circuit pairs arranged in an array, each circuit pair comprising two pixel driving circuits adjacent in a same row; and within a same circuit pair, a first terminal of a third transistor of one pixel driving circuit is reused as a first terminal of a third transistor of the other pixel driving circuit.

20. The display panel according to claim 1, wherein the pixel driving circuit comprises a first transistor, a second transistor, a third transistor, and a storage capacitor, wherein a first terminal of the first transistor is electrically connected to a driving power voltage signal line for loading a driving power voltage; a first terminal of the second transistor is electrically connected to a data signal line for loading a data voltage; a first terminal of the third transistor is electrically connected to a sensing signal line; a gate of the first transistor is electrically connected to a second terminal of the second transistor and a first electrode plate of the storage capacitor; a second terminal of the first transistor is electrically connected to a second terminal of the third transistor, a pixel electrode of the pixel layer, and a second electrode plate of the storage capacitor;
the scan signal line comprises a first scan signal line and a second scan signal line; the gate of the second transistor is electrically connected to the first scan signal line, and the gate of the third transistor is electrically connected to the second scan signal line; and
the gate, the first terminal, and the second terminal of the third transistor are all located on the same side of the second scan signal line.

21. The display panel according to claim 1, wherein the planarization layer has a pixel electrode via hole, and a pixel electrode of the pixel layer is electrically connected to an output terminal of the pixel driving circuit through the pixel electrode via hole; and
a pixel opening of a sub-pixel driven by the pixel driving circuit and a pixel electrode opening corresponding to the pixel driving circuit are respectively located on two sides of the scan signal line to which the gate of the third transistor is connected.

22. The display panel according to claim 21, wherein the second metal layer comprises a first metal structure, the first metal structure being electrically connected to a second electrode plate of the storage capacitor through a fifth via hole and electrically connected to the second terminal of the third transistor through a second via hole; and an orthographic projection of the pixel electrode via hole on the substrate base is overlapped with at least one of an orthographic projection of the fifth via hole on the substrate base and an orthographic projection of the second via hole on the substrate base.

23. A display device, comprising the display panel according to any one of claims 1 to 22.
